# EUROPEAN PATENT SPECIFICATION

(11) **EP 4 436 147 B1**
(45) Date of publication and mention of the grant of the patent: **24.09.2025**
(21) Application number: 23805848.1
(22) Date of filing: 02.11.2023
(51) Int. Cl.: H04M 1/02, G06F 1/16

(54) **ELECTRONIC DEVICE COMPRISING FLEXIBLE DISPLAY**
ELEKTRONISCHE VORRICHTUNG MIT FLEXIBLER ANZEIGE
DISPOSITIF ÉLECTRONIQUE COMPRENANT UN ÉCRAN SOUPLE

(30) Priority: 07.03.2023 KR 20230030207; 31.01.2023 KR 20230013333
(43) Date of publication of application: 25.09.2024
(73) Proprietor: Samsung Electronics Co., Ltd., Suwon-si, Gyeonggi-do 16677 (KR)
(72) Inventor: AN, Jungchul, Suwon-si, Gyeonggi-do 16677 (KR); KIM, Sangkyu, Suwon-si, Gyeonggi-do 16677 (KR); RYU, Kwanghee, Suwon-si, Gyeonggi-do 16677 (KR); YOON, Shinhyuk, Suwon-si, Gyeonggi-do 16677 (KR)
(74) Representative: Appleyard Lees IP LLP
(86) International application number: PCT/KR2023/017411
(87) International publication number: WO 2024/162565

(56) References cited:
- KR-A- 20200 137 902
- KR-A- 20200 137 948
- KR-A- 20210 087 316
- KR-A- 20220 001 528
- KR-A- 20220 065 952
- US-A1- 2021 004 049
- US-A1- 2021 294 383
- US-A1- 2023 009 765

## Description

### Technical Field

The present disclosure relates to an electronic device including a flexible display.

### Background Art

An electronic device including a large-screen display may increase user utilization. As a demand for an electronic device having high portability increases, the electronic device may include a deformable display. The deformable display may be slidably deformable, pivotably deformable, or rollably deformable. For example, the deformable display may include a flexible area that may be folded or unfolded.

The above-described information may be provided as a related art for the purpose of helping to understand the present disclosure. No claim or determination is raised as to whether any of the above-described information may be applied as a prior art related to the present disclosure.

US 2021/0294383 A1, US 2023/0009765 A1 and US 2021/0004049 A1 all relate an electronic device including a first housing, a second housing, and a hinge housing.

### Disclosure

### Technical Solution

The invention is defined by the appended independent claim.

An electronic device is provided. The electronic device may include a first housing, a second housing, a flexible display, a cover sheet, and a support plate. The second housing may be rotatable to the first housing with respect to a folding axis. The flexible display may include a first display area, a second display area, and a third display area. The first display area may be disposed on the first housing. The second display area may be disposed on the second housing. The third display area may be disposed along the folding axis between the first display area and the second display area. The third display area may be deformed based on the second housing rotated with respect to the first housing. The cover sheet may be disposed along at least a portion of edge of the third display area intersecting the folding axis. The support plate may be located below the cover sheet to support the cover sheet and extended from at least a portion of the edge along the folding axis.

An electronic device is provided. The electronic device may include a first housing, a second housing, a flexible display, a cover sheet, a support plate, and a hinge structure. The second housing may be rotatable to the first housing with respect to a folding axis. The flexible display may include a first display area, a second display area, and a third display area. The first display area may be disposed on the first housing. The second display area may be disposed on the second housing. The third display area may be disposed along the folding axis between the first display area and the second display area. The third display area may be deformed based on the second housing rotated with respect to the first housing. The cover sheet may be disposed along at least a portion of edge of the third display area intersecting the folding axis. The support plate may be located below the cover sheet to support the cover sheet. The support plate may be extended from at least a portion of the edge along the folding axis. The hinge structure may include a first hinge plate and a second hinge plate. The first hinge plate may be connected to the first housing. The second hinge plate may be connected to the second housing. The second hinge plate may be rotatable to the first hinge plate with respect to the folding axis. The support plate may be located between the hinge structure and the flexible display. A rotation angle range of the first hinge plate and the second hinge plate may be larger than a rotation angle range of the first housing and the second housing.

### Description of the Drawings

FIG. 1 is a block diagram of an electronic device in a network environment according to an embodiment.
FIG. 2A illustrates an example of an unfolded state of an exemplary electronic device.
FIG. 2B illustrates an example of a folded state of an exemplary electronic device.
FIG. 2C is an exploded view of an exemplary electronic device.
FIG. 3A is a front view of an exemplary electronic device.
FIG. 3B is an exploded perspective view of an exemplary electronic device.
FIG. 4A is a front view of an exemplary electronic device to which a display is omitted.
FIG. 4B is an enlarged view of X area of FIG. 4A.
FIG. 5A is a cross-sectional view of an exemplary electronic device cut along A-A' of FIG. 3A.
FIG. 5B is a cross-sectional view of an exemplary electronic device cut along B-B' of FIG. 3A.
FIG. 5C is a cross-sectional view of an exemplary electronic device cut along C-C' of FIG. 3A.
FIG. 6 illustrates a portion of an exemplary electronic device.
FIG. 7A illustrates a partial area of an exemplary electronic device to which an outer layer of a flexible display is omitted.
FIG. 7B is a cross-sectional view of an exemplary electronic device cut along D-D' of FIG. 7A.
FIG. 8 illustrates a durability test for a flexible display of an exemplary electronic device.
FIG. 9A is a cross-sectional view of an exemplary electronic device in an unfolded state.
FIG. 9B is a cross-sectional view of an exemplary electronic device in a folded state.
FIG. 9C is an exploded view of a hinge structure of an exemplary electronic device.

### Mode for Invention

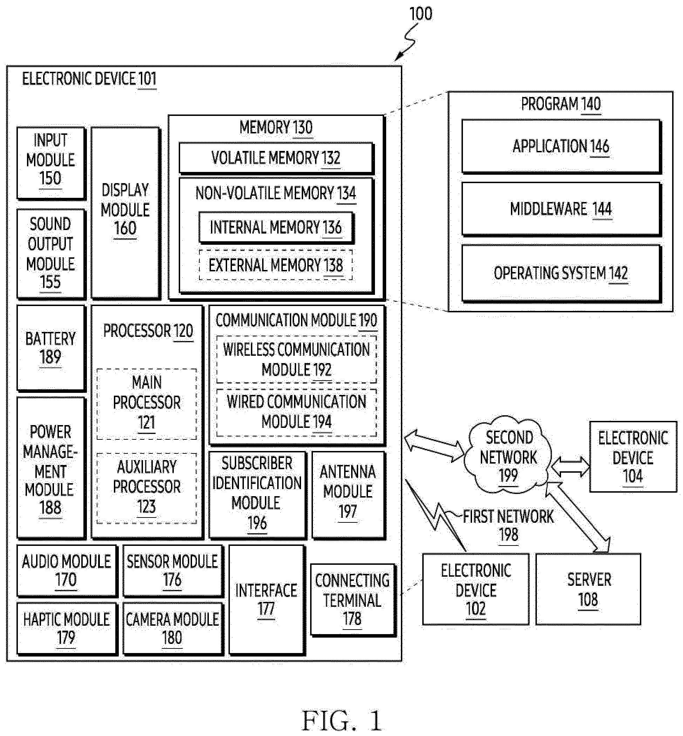

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beamforming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (loT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or loT-related technology.

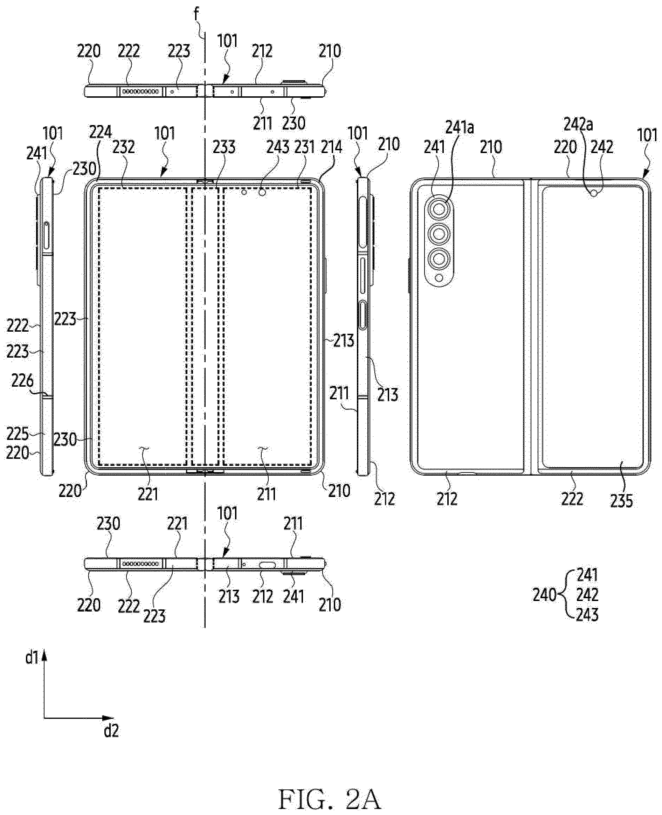

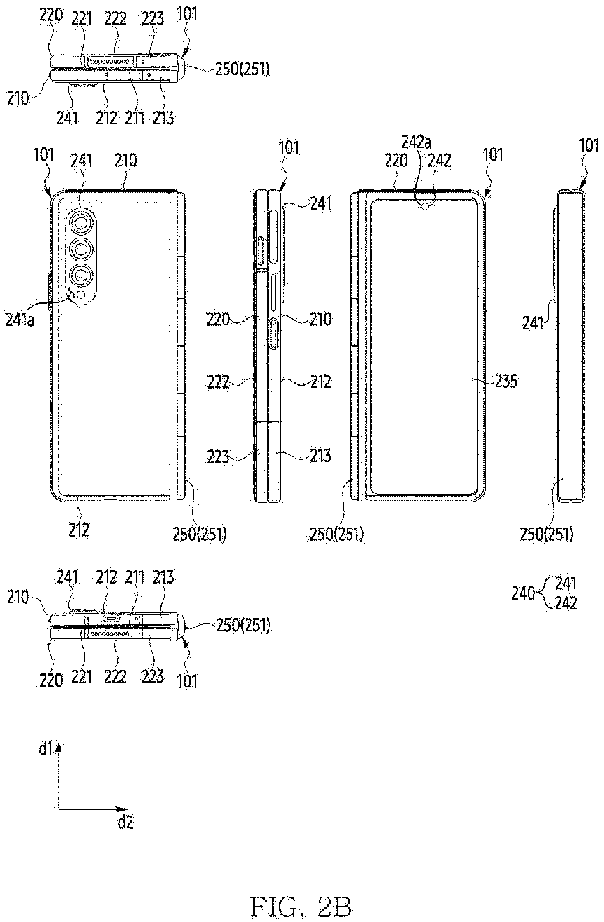

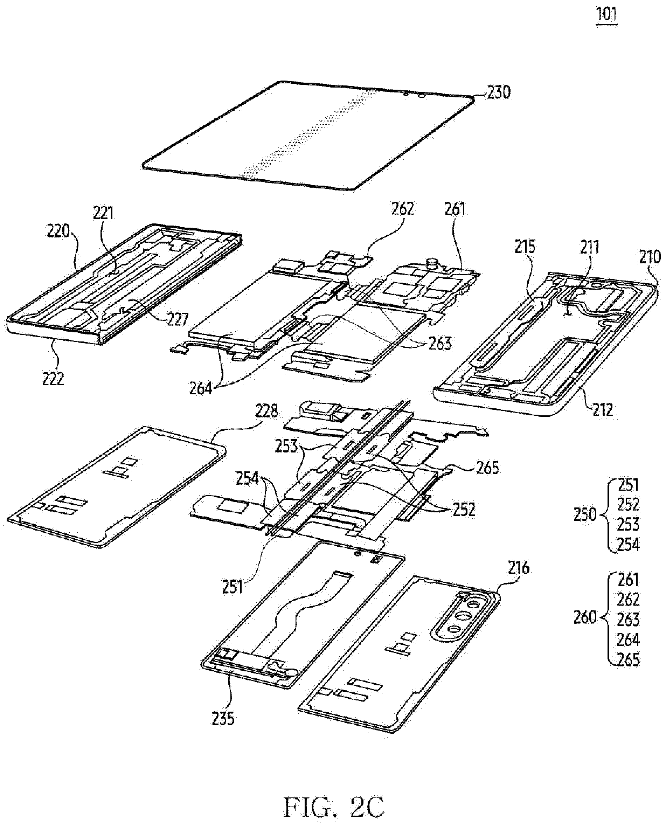

FIG. 2A illustrates an example of an unfolded state of an exemplary electronic device. FIG. 2B illustrates an example of a folded state of an exemplary electronic device. FIG. 2C is an exploded view of an exemplary electronic device.

Referring to FIG. 2A, FIG. 2B, and FIG. 2C, an electronic device 101 (e.g., the electronic device 101 of FIG. 1) may include a first housing 210, a second housing 220, a flexible display 230 (e.g., the display module 160 of FIG. 1), at least one camera 240, a hinge structure 250, and/or at least one electronic component 260.

For example, the first housing 210 and the second housing 220 may form at least portion of exterior of the electronic device 101. For example, the first housing 210 may include a first surface 211, a second surface 212 opposite to the first surface 211, and a first side surface 213 between the first surface 211 and the second surface 212. The first side surface 213 may connect an edge of the first surface 211 and an edge of the second surface 212. The first surface 211, the second surface 212, and the first side surface 213 may form an inner space of the first housing 210. For example, the first housing 210 may provide a space formed by the first surface 211, the second surface 212, and the first side 213 as a space for arranging components of the electronic device 101.

For example, the second housing 220 may include a third surface 221, a fourth surface 222 opposite to the third surface 221, and a second side surface 223 between the third surface 221 and the fourth surface 222. The second side surface 223 may connect an edge of the third surface 221 and an edge of the fourth surface 222. The third surface 221, the fourth surface 222, and the second side surface 223 may form an inner space of the second housing 220. For example, the second housing 220 may provide a space formed by the second side surface 223 surrounding the third surface 221, the fourth surface 222, and at least portion of the third surface 221 and the fourth surface 222 as a space for mounting components of the electronic device 101. For example, the second housing 220 may be coupled to the first housing 210 to be rotatable with respect to the first housing 210.

For example, the first housing 210 may include a first side surface member 214 that forms the first side surface 213. For example, the second housing 220 may include a second side surface member 224 that forms the second side surface 223. For example, the first side surface member 214 may surround at least a portion of the edge of the first display area 231 of the flexible display 230. For example, the second side surface member 224 may surround at least a portion of the edge of the second display area 232 of the flexible display 230.

For example, the first side member 214 and the second side member 224 may include a conductive portion 225 and a non-conductive portion 226. For example, at least one conductive portion 225 may be used as an antenna radiator for communication with an external electronic device.

For example, flexible display 230 may be configured to display visual information. For example, the flexible display 230 may be disposed across the hinge structure 250 on the first surface 211 of the first housing 210 and the third surface 221 of the second housing 220. For example, the flexible display 230 may include a first display area 231 disposed on the first surface 211 of the first housing, a second display area 232 disposed on the third surface 221 of the second housing, and a third display area 233 disposed between the first display area 231 and the second display area 232. For example, the first display area 231, the second display area 232, and the third display area 233 may form a front surface of the flexible display 230. For example, the electronic device 101 may further include a sub-display panel 235 disposed on the fourth surface 222 of the second housing 220. For example, the flexible display 230 may include a window exposed toward outside of the electronic device 101. The window may protect a surface of the flexible display 230. The window may include a substantially transparent material and transmit visual information provided by the flexible display 230 to the outside of the electronic device 101. For example, the window may include glass (e.g., ultra-thin glass (UTG)) and/or polymer (e.g., polyimide (PI)), but is not limited thereto.

For example, at least one camera 240 may be configured to obtain an image based on receiving light from an external subject of the electronic device 101. For example, the at least one camera 240 may include first cameras 241, a second camera 242, or a third camera 243. In an embodiment, the first cameras 241 may be disposed in the first housing 210. For example, the first cameras 241 may be disposed inside the first housing 210. For example, at least a portion of the first cameras 241 may be visible through the second surface 212 of the first housing 210. The first cameras 241 may be supported by a bracket (not shown) in the first housing 210. For example, the first housing 210 may include at least one opening 241a overlapping the first cameras 241 when the electronic device 101 is viewed from above. The first cameras 241 may obtain an image based on receiving light from the outside of the electronic device 101 through the at least one opening 241a.

For example, the second camera 242 may be disposed in the second housing 220. For example, the second camera 242 may be disposed inside the second housing 220 and may be at least partially visible through the sub-display panel 235. The second housing 220 may include at least one opening 242a overlapping the second camera 242 when the electronic device 101 is viewed from above. The second camera 242 may obtain an image based on receiving light from the outside of the electronic device 101 through the at least one opening 242a.

For example, the third camera 243 may be disposed in the first housing 210. For example, the third camera 243 may be disposed inside the first housing 210. For example, at least a portion of the third camera 243 may be visible through the first surface 211 of the first housing 210. For example, the third camera 243 may be disposed inside the first housing 210 and may be at least partially visible through the first display area 231 of the flexible display 230. The first display area 231 of the flexible display 230 may include at least one opening overlapping the third camera 243 when the flexible display 230 is viewed from above. The third camera 243 may obtain an image based on receiving light from the outside of the flexible display 230 through at least one opening.

For example, the second camera 242 and the third camera 243 may be disposed under the flexible display 230 (e.g., a direction toward the inside of the first housing 210 or the inside of the second housing 220). For example, the second camera 242 and/or the third camera 243 may be an under display camera (UDC). For example, when the second camera 242 and/or the third camera 243 are under-display cameras, an area of the flexible display 230 corresponding to each position of the second camera 242 and the third camera 243 may not be an inactive area. The inactive area of the flexible display 230 may refer to an area of the flexible display 230 that does not include a pixel or emits light to the outside of the electronic device 101. As another example, the second camera 242 and the third camera 243 may be a punch hole camera. When the second camera 242 and the third camera 243 are punch hole cameras, an area of the flexible display 230 corresponding to each position of the second camera 242 and the third camera 243 may be an inactive area.

For example, the hinge structure 250 may rotatably connect the first housing 210 and the second housing 220. For example, the hinge structure 250 may be disposed between the first housing 210 and the second housing 220 of the electronic device 101. For example, the hinge structure 250 may be disposed between a portion of the first side surface 213 and a portion of the second side surface 223. The hinge structure 250 may be changed to an unfolded state in which a direction in which the first surface 211 of the first housing 210 faces is substantially the same as a direction in which the third surface 221 of the second housing 220 faces, or a folded state in which a direction in which the first surface 211 faces is substantially opposite to a direction in which the third surface 221 faces. When the electronic device 101 is in a folded state, the first housing 210 and the second housing 220 may be stacked or overlapped. For example, when the electronic device 101 is in a folded state, a direction in which the first surface 211 faces may be different from a direction in which the third surface 221 faces. For example, when the electronic device 101 is in a folded state, a direction in which the first surface 211 faces may be opposite to a direction in which the third surface 221 faces.

For example, the electronic device 101 may be foldable based on a folding axis f. The folding axis f may refer to a virtual line extending by passing the hinge cover 251 in a direction (e.g., d1 of FIGS. 2A and 2B) parallel to a longitudinal direction of the electronic device 101, but is not limited thereto. For example, the folding axis f may be a virtual line extending in a direction (e.g., d2 of FIG. 2A and FIG. 2B) perpendicular to the longitudinal direction of the electronic device 101. When the folding axis f extends in a direction perpendicular to the longitudinal direction of the electronic device 101, the hinge structure 250 may extend in a direction parallel to the folding axis f to connect the first housing 210 and the second housing 220. The first housing 210 and the second housing 220 may be rotatable by the hinge structure 250 extending in a direction perpendicular to the longitudinal direction of the electronic device 101.

For example, the hinge structure 250 may include a hinge cover 251, a first hinge plate 252, a second hinge plate 253, and a hinge module 254. The hinge cover 251 may cover internal components of the hinge structure 250. For example, when the electronic device 101 is in a folded state, the hinge cover 251 surrounding the hinge structure 250 may be at least partially exposed to the outside of the electronic device 101 through the first housing 210 and the second housing 220. For example, when the electronic device 101 is in an unfolded state, the hinge cover 251 may be covered by the first housing 210 and the second housing 220 and may not be exposed to the outside of the electronic device 101.

For example, the first hinge plate 252 and the second hinge plate 253 may be coupled to the first housing 210 and the second housing 220 respectively to rotatably connect the first housing 210 and the second housing 220. For example, the first hinge plate 252 may be coupled to a first support member 215 of the first housing 210. For example, the second hinge plate 253 may be coupled to a second support member 227 of the second housing 220. For example, the first housing 210 and the second housing 220 may be rotated based on a rotation of the first hinge plate 252 and the second hinge plate 253.

For example, the hinge module 254 may rotate the first hinge plate 252 and the second hinge plate 253. For example, the hinge module 254 may include gears that are rotatable by being engaged with each other. For example, the first hinge plate 252 and the second hinge plate 253 may be rotated based on the folding axis f by the gears. For example, the hinge modules 254 may be multiple.

For example, the first housing 210 may include the first support member 215 and a first cover 216. For example, the second housing 220 may include the second support member 227 and a second cover 228. The first support member 215 may be disposed inside the first housing 210 and may support components of the electronic device 101. The first cover 216 may cover the second surface 212 of the first housing 210. The second support member 227 may be disposed inside the second housing 220 and may support components of the electronic device 101. The second cover 228 may cover the fourth surface 222 of the second housing 220. For example, the second cover 228 may be omitted. For example, when the second cover 228 is omitted, the sub-display panel 235 may cover the fourth surface 222.

For example, a portion of the first support member 215 may be surrounded by the first side surface 213. For example, a portion of the second support member 227 may be surrounded by the second side surface 223. For example, the first support member 215 may be integrally formed with the first side surface 213. For example, the second support member 227 may be integrally formed with the second side surface 223. For example, the first support member 215 may be implemented as a component independent of the first side surface 213. For example, the second support member 227 may be implemented as a component independent of the second side surface 223.

For example, at least one electronic component 260 may implement various functions for providing to a user. For example, the at least one electronic component 260 may include a first printed circuit board 261, a second printed circuit board 262, a flexible printed circuit board 263, a battery 264, and/or an antenna 265. For example, the first printed circuit board 261 and the second printed circuit board 262 may provide an electrical connection of components in the electronic device 101, respectively.

For example, the first printed circuit board 261 may be disposed in the first housing 210. For example, the first printed circuit board 261 may be disposed on one surface of the first support member 215. For example, the second printed circuit board 262 may be disposed in the second housing 220. For example, the second printed circuit board 262 may be disposed on one surface of the second support member 227. The flexible printed circuit board 263 may connect the first printed circuit board 261 and the second printed circuit board 262. For example, the flexible printed circuit board 263 may extend from the first printed circuit board 261 to the second printed circuit board 262.

For example, the battery 264 is a device for supplying power to at least one component of the electronic device 101, and may include, for example, a non-rechargeable primary battery, a rechargeable secondary battery, or a fuel cell.

For example, the antenna 265 may be configured to receive power or a signal from the outside of the electronic device 101. For example, the antenna 265 may include a near field communication (NFC) antenna, an antenna module, and/or a magnetic secure transmission (MST) antenna. For example, the antenna 265 may perform short-range communication with an external device or wirelessly transmit and/or receive power required for charging.

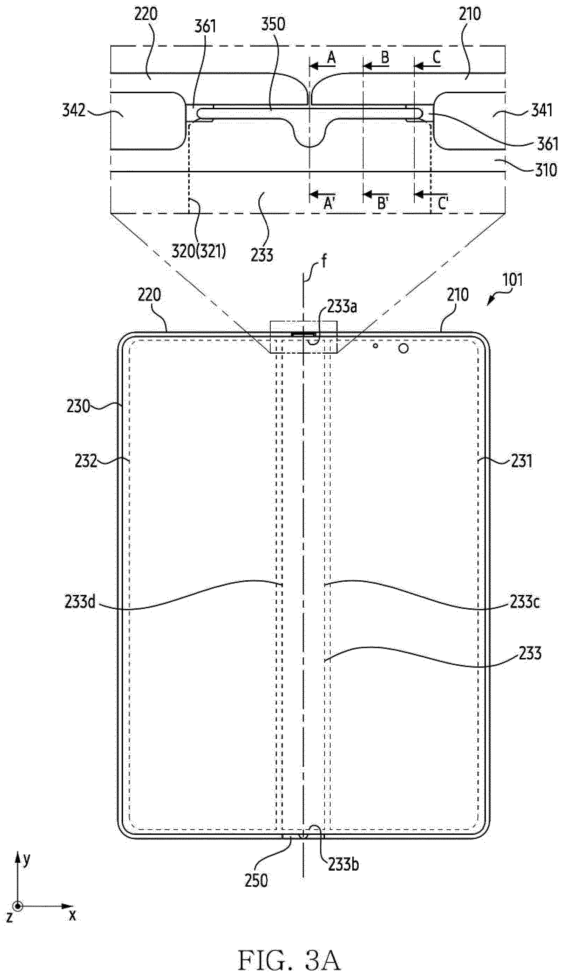

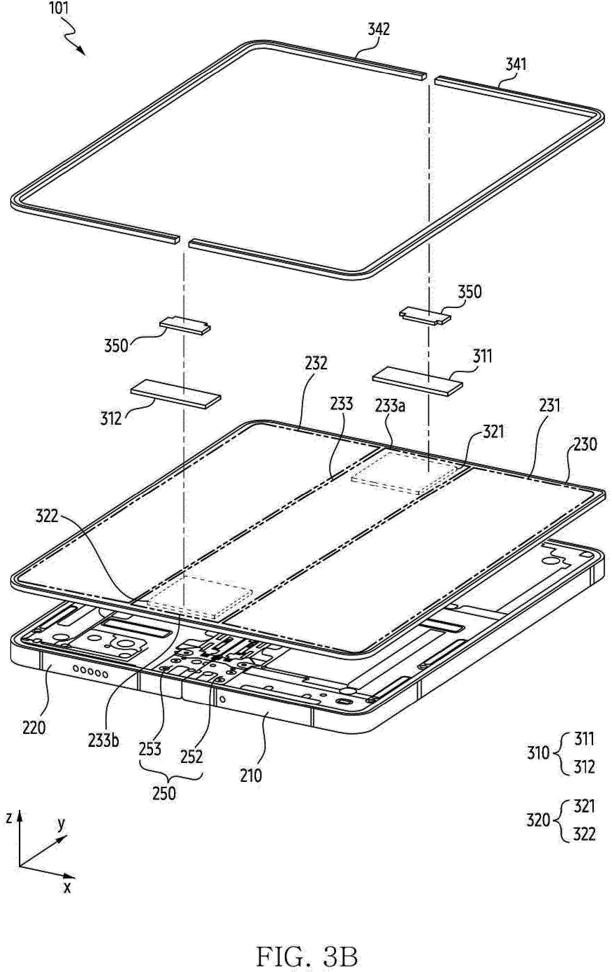

FIG. 3A is a front view of an exemplary electronic device. FIG. 3B is an exploded perspective view of an exemplary electronic device.

Referring to FIGS. 3A and 3B, an exemplary electronic device 101 may include a first housing 210, a second housing 220, a flexible display 230, a cover sheet 310, and a support plate 320.

The exemplary electronic device 101 may include the first housing 210 and the second housing 220 that are rotatably coupled. The hinge structure 250 disposed between the first housing 210 and the second housing 220 may rotatably couple the first housing 210 and the second housing 220. For example, the second housing 220 may be configured to be rotatable to the first housing 210 with respect to a folding axis f.

For example, the flexible display 230 may be disposed on the first housing 210, the second housing 220, and the hinge structure 250. For example, the flexible display 230 may include a first display area 231, a second display area 232, and a third display area 233. The first display area 231 may be disposed on the first housing 210. The second display area 232 may be disposed on the second housing 220. The third display area 233 may be disposed between the first display area 231 and the second display area 232. The third display area 233 may be disposed along the folding axis f. For example, the third display area 233 may be deformed based on the second housing 220 rotated with respect to the first housing 210. For example, in an unfolded state in which a direction the first display area 231 faces is the same as a direction the second display area 232 faces, the third display area 233 may be substantially flat. For example, in a folded state in which a direction the first display area 231 faces and a direction the second display area 232 faces are opposite to each other, the third display area 233 may be bent.

For example, the third display area 233 may include edges 233a and 233b intersecting the folding axis f and edges 233c and 233d extending along the folding axis f. For example, the third display area 233 may include a first edge 233a, a second edge 233b, a third edge 233c, and a fourth edge 233d. The first edge 233a may intersect the folding axis f. The second edge 233b may intersect the folding axis f and be opposite to the first edge 233a. For example, the first edge 233a may be an edge in a +y direction of the third display area 233, and the second edge 233b may be an edge in a -y direction of the third display area 233, but is not limited thereto. The third edge 233c may extend along the folding axis f and may be in contact with the first display area 231. The fourth edge 233d may extend along the folding axis f and may be in contact with the second display area 232.

Referring to FIG. 3B, the exemplary electronic device 101 may include frames 341 and 342 that at least partially surround edges 233a and 233b that intersect the folding axis f of the flexible display 230. For example, the electronic device 101 may include the first frame 341 at least partially surrounding the edges of the first display area 231, and the second frame 342 at least partially surrounding the edges of the second display area 232. The first frame 341 may be disposed on the first display area 231 and may protect edges of the first display area 231. The second frame 342 is disposed on the second display area 232 and may protect edges of the second display area 232. For example, the edges of the first display area 231 surrounded by the first frame 341 may not be exposed to the outside. For example, the edges of the second display area 232 surrounded by the second frame 342 may not be exposed to the outside.

Since the third display area 233 may be deformed according to a rotation operation of the first housing 210 and/or the second housing 220, it may be difficult for the third display area 233 to be deformed by the rotation operation when the first frame 341 and the second frame 342 surround edges 233a and 233b intersecting the folding axis f of the third display area 233. For example, the first frame 341 and the second frame 342 may be spaced apart from each other so as not to interfere with the deformation of the third display area 233. For example, the first frame 341 may be spaced apart from the second frame 342 with the third display area 233 in between. The first edge 233a and the second edge 233b of the third display area 233 may be located between the first frame 341 and the second frame 342.

For example, the cover sheet 310 may be disposed along at least a portion of an edge (e.g., the first edge 233a and/or the second edge 233b) of the third display area 233 intersecting the folding axis f. Since the first frame 341 and the second frame 342 are spaced apart from the first edge 233a and the second edge 233b, the first edge 233a and the second edge 233b may be exposed to the outside. The cover sheet 310 may cover the first edge 233a and/or the second edge 233b exposed between the first frame 341 and the second frame 342. For example, the cover sheet 310 may cover a gap between the first frame 341 and the second frame 342. For example, the cover sheet 310 may block a foreign substance (e.g., dust) from entering the electronic device 101, by covering the edges 233a and 233b of the third display area 233 exposed through the gap between the first frame 341 and the second frame 342. For example, the cover sheet 310 may block a foreign substance entering through a space between the third display area 233 and the first housing 210 and a space between the third display area 233 and the second housing 220.

Referring to FIG. 3B, the cover sheet 310 may include a first cover sheet 311 disposed along at least a portion of the first edge 233a and a second cover sheet 312 disposed along at least a portion of the second edge 233b. The second cover sheet 312 may be spaced apart from the first cover sheet 311 in a direction parallel to the folding axis f. For example, the second cover sheet 312 may be spaced apart from the first cover sheet 311 in the -y direction.

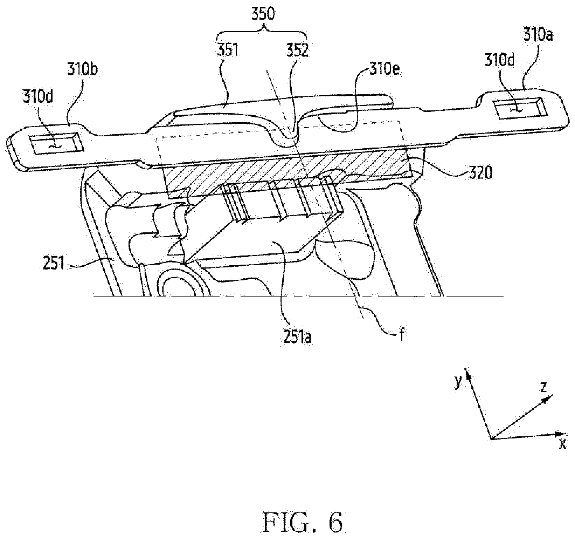

For example, the cover sheet 310 may be disposed between the flexible display 230 and the frames 341 and 342. For example, the cover sheet 310 may be coupled under the frames 341 and 342 (e.g., in the -z direction). The cover sheet 310 may be supported by a cap 350 in contact with the cover sheet 310. The cap 350 may be disposed in a gap between the first frame 341 and the second frame 342 and may be in contact with the cover sheet 310. At least a portion (e.g., a second body 352 of FIG. 6) of the cap 350 may overlap the folding axis f so as not to interfere with a folding operation and an unfolding operation of the electronic device 101. For example, when the electronic device 101 is in a folded state, at least a portion of the cap 350 may be located between the first display area 231 and the second display area 232. The cap 350 may be rigid to support cover sheet 310. A portion of a dust sheet 361 attached to the hinge structure 250 may be exposed between the cap 350 and the frames 341 and 342. A connection structure between the cover sheet 310 and the cap 350 will be illustrated in FIG. 6.

For example, the cover sheet 310 is a thin sheet and may be flexible rather than rigid so that it may stretched or reduced according to an operation of the hinge structure 250. For example, the cover sheet 310 may be made of a flexible material (e.g., rubber). Since the cover sheet 310 is not rigid, it may be difficult to firmly support the first edge 233a and the second edge 233b of the third display area 233. When a separate structure supporting the first edge 233a and the second edge 233b is not present, the first edge 233a and the second edge 233b may be easily damaged by an external force.

The exemplary electronic device 101 may include the support plate 320 for providing rigidity to the first edge 233a and the second edge 233b by supporting the cover sheet 310. The support plate 320 may be located below the cover sheet 310 (e.g., in the -z direction) to support the cover sheet 310. For example, the support plate 320 may be located between the hinge structure 250 and the flexible display 230. The cover sheet 310 exposed through the gap between the first frame 341 and the second frame 342 may be supported by the support plate 320. The support plate 320 may be a rigid sheet capable of supporting the cover sheet 310. As the support plate 320 that is rigid supports the cover sheet 310 that is flexible, the cover sheet 310 and the edges 233a and 233b of the third display area 233 may be protected. Referring to FIG. 3B, the support plate 320 may include a first support plate 321 configured to support the first cover sheet 311 and the first edge 233a, and a second support plate 322 configured to support the second edge 233b.

For example, the support plate 320 may be configured to support the cover sheet 310 and the edges 233a and 233b of and the third display area 233. For example, the support plate 320 may have a wider width than the gap to support the cover sheet 310 exposed through the gap between the first frame 341 and the second frame 342. For example, the support plate 320 may overlap the cover sheet 310 to support the cover sheet 310. For example, when the electronic device 101 is viewed from above, at least a portion of the support plate 320 may be configured to support the cover sheet 310 by overlapping the cover sheet 310. The support plate 320 may have a structure that supports the cover sheet 310 but does not interfere with a rotation operation of the first housing 210 and/or the second housing 220. Hereinafter, a detailed structure of the support plate 320 will be described with reference to the drawings.

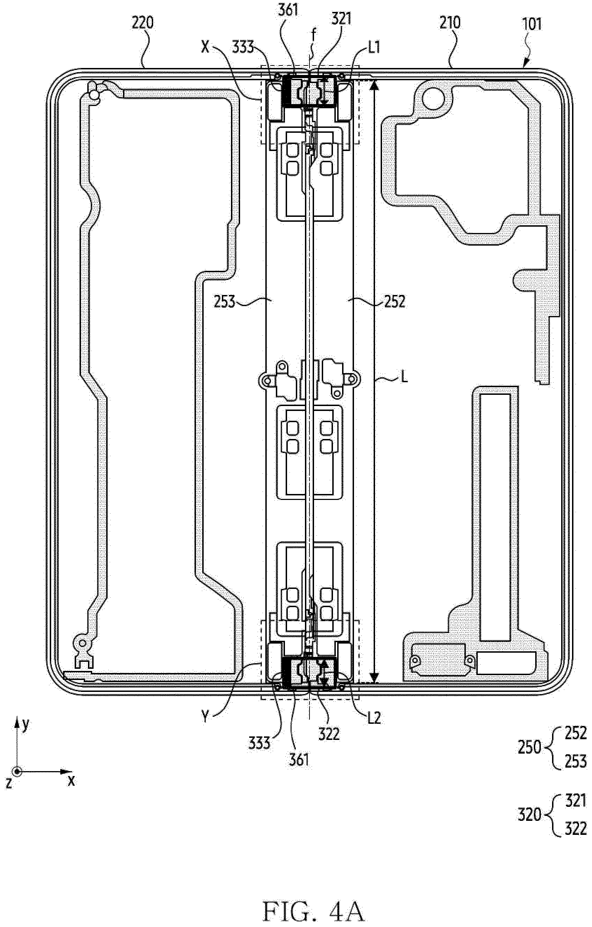

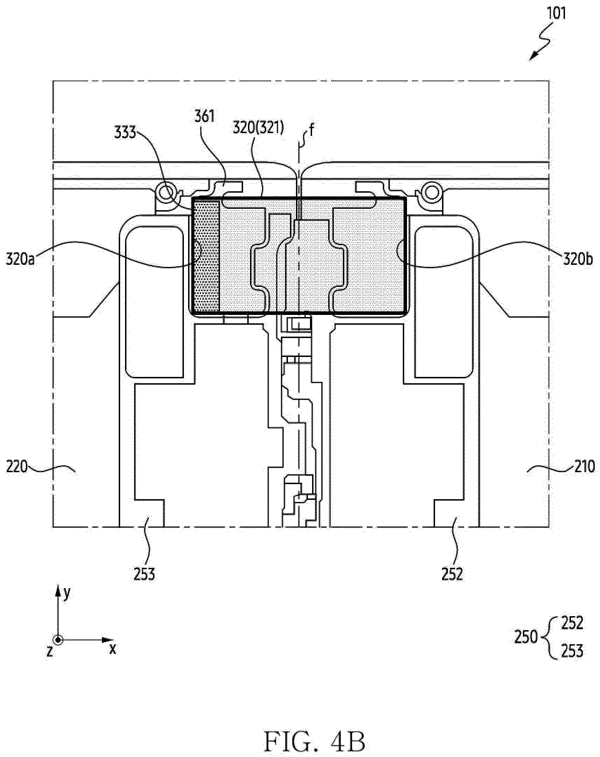

FIG. 4A is a front view of an exemplary electronic device to which a display is omitted. FIG. 4B is an enlarged view of the X area of FIG.4A.

Since an Y area of FIG. 4A has a structure symmetrical to an X area of FIG. 4B, descriptions described with reference to FIG. 4B may be applied substantially equally to the Y area of FIG. 4A.

Referring to FIGS. 4A and 4B, an exemplary electronic device 101 may include a support plate 320. For example, the support plate 320 may be located between a third display area (e.g., the third display area 233 of FIG. 3A) and the hinge structure 250, by being located on a hinge structure 250 (e.g., in the +z direction). The support plate 320 may be a rigid sheet. For example, the support plate 320 may be a metal sheet, but is not limited thereto.

For example, the hinge structure 250 may include a first hinge plate 252, a second hinge plate 253, and a hinge cover (e.g., a hinge cover 251 of FIG. 4B). The hinge structure 250 may be disposed below the third display area 233 (e.g., in the -z direction). The first hinge plate 252 may be connected to the first housing 210. The second hinge plate 253 may be connected to the second housing 220. When the user applies an external force to fold or unfold the electronic device 101, the first housing 210 and the second housing 220 may be folded or unfolded to each other through a rotational movement of the first hinge plate 252 and the second hinge plate 253. The hinge cover 251 may be disposed below the first hinge plate 252 and the second hinge plate 253 (e.g., in the -z direction), and may partially surround the first hinge plate 252 and the second hinge plate 253.

For example, the support plate 320 may be located on the first hinge plate 252 and the second hinge plate 253. For example, a dust sheet (e.g., a dust sheet 361 of FIG. 4B) may be attached on the hinge cover 251, the first hinge plate 252, and the second hinge plate 253. The support plate 320 may be located on the dust sheet 361 attached on the first hinge plate 252 and the second hinge plate 253. The support plate 320 may extend from one position of the first hinge plate 252 to one position of the second hinge plate 253, over the folding axis f. Since the support plate 320 located on the first hinge plate 252 and the second hinge plate 253 extends over the folding axis f, the support plate 320 may be affected by an operation of the hinge structure 250. The support plate 320 may be configured not to interfere with a rotation operation of the hinge structure 250.

For example, the support plate 320 may be attached to either the first hinge plate 252 or the second hinge plate 253. For example, the support plate 320 may be attached to the second hinge plate 253 through an attachment member 333. In a folded state, the support plate 320 may be disposed across the first hinge plate 252 and the second hinge plate 253. When the electronic device 101 changes from the folded state to the folded state, the support plate 320 may be bent while moving along the second hinge plate 253.

For example, the support plate 320 may be attached to the second hinge plate 253 through the attachment member 333 (e.g., a pressure sensitive adhesive (PSA)). An end 320a of the support plate 320 may be attached to the second hinge plate 253, and another end 320b may not be attached to the first hinge plate 253. The other end 320b may be movable along the end 320a attached to the second hinge plate 253. When the electronic device 101 changes from the folded state to the folded state in a state that the support plate 320 is attached to the second hinge plate 253, the first hinge plate 252 and the second hinge plate 253 may rotate. The end 320a of the support plate 320 attached to the second hinge plate 253 may move along the second hinge plate 253, and the other end 320b may move along the end 320a. In the folded state, a portion of the support plate 320 disposed on the second hinge plate 253 may be flat along the second hinge plate 253, and a remaining portion of the support plate 320 spaced apart from the second hinge plate 253 may be bent along a curved shape of the third display area 233. Since the support plate 320 is attached to only one of the first hinge plate 252 and the second hinge plate 253, the support plate 320 may not interfere with a rotation operation of the first hinge plate 252 and the second hinge plate 253.

For example, the support plate 320 may extend along the folding axis f from at least a portion of an edge (e.g., the first edge 233a and the second edge 233b of FIG. 3A) of the third display area (e.g., the third display area 233 of FIG. 3A). For example, the support plate 320 may include a first support plate 321 and a second support plate 322. The first support plate 321 may be located below the first cover sheet 311 to support the first cover sheet (e.g., the first cover sheet 311 of FIG. 3B). The second support plate 322 may be located below the second cover sheet 312 to support the second cover sheet (e.g., the second cover sheet 312 of FIG. 3B). The first support plate 321 and the second support plate 322 may extend along the folding axis f. For example, the first support plate 321 may extend from the first edge 233a in the -y direction. For example, the second support plate 322 may extend from the second edge 233b in the +y direction.

For example, each of the first support plate 321 and the second support plate 322 may be attached to either the first hinge plate 252 or the second hinge plate 253, through an attachment member 333. As illustrated in FIG. 4A, a portion where the first support plate 321 is attached to the attachment member 333 and a portion where the second support plate 322 is attached to the attachment member 333 may be asymmetric, but are not limited thereto. For example, the portion where the first support plate 321 is attached to the attachment member 333 and the portion where the second support plate 322 is attached to the attachment member 333 may be symmetrical to each other.

Referring to FIG. 4A, the support plate 320 extending along the folding axis f may be located on a portion of the hinge structure 250. For example, a length in which the support plate 320 extends along the folding axis f may be shorter than a length of the third display area (e.g., the third display area 233 of FIG. 3A) and/or a length L of the hinge structure 250. For example, the sum of a first length L1 in which the first support plate 321 extends along the folding axis f and a second length L2 in which the second support plate 322 extends along the folding axis f may be shorter than a length of a third display area 233 and/or the length L of the hinge structure 250. Since the sum of the first length L1 and the second length L2 is shorter than the length of the third display area 233 and/or the length L of the hinge structure 250, the second support plate 322 may be spaced apart from the first support plate 321 in a direction parallel to the folding axis f. The support plate 320 may include the first support plate 321 and the second support plate 322 that are not integrally formed along the third display area 233 and/or the hinge structure 250 and are spaced apart from each other in a direction parallel to the folding axis f. The first support plate 321 and the second support plate 322 spaced apart from each other may support a first cover sheet (e.g., the first cover sheet 311 of FIG. 3B) and a second cover sheet (e.g., the second cover sheet 312 of FIG. 3B) and may not interfere with a rotation operation of the hinge structure 250. The first support plate 321 and the second support plate 322 are disposed only in an area for supporting the cover sheet 310, so that unnecessary a subsidiary material is not required, it does not interfere with the repeatedly rotating hinge structure 250, and the manufacturing cost may be lowered.

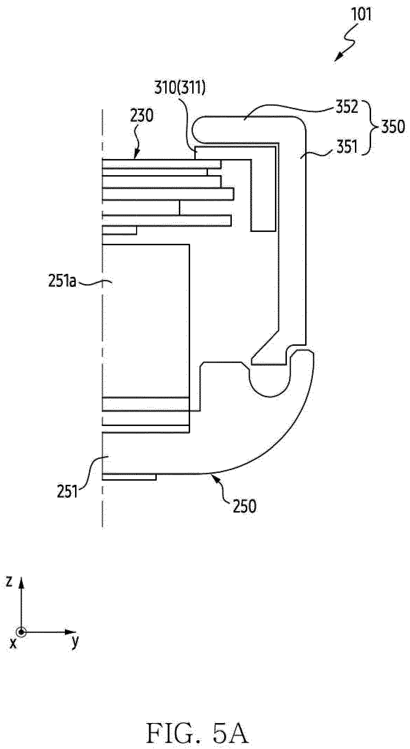

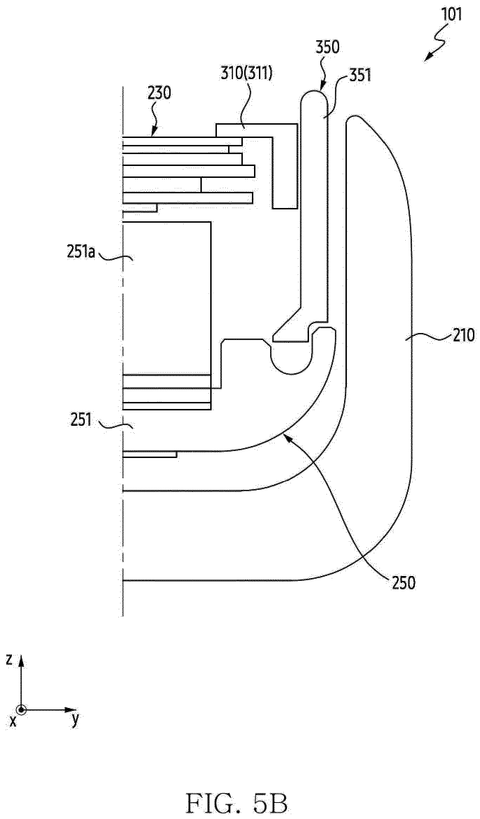

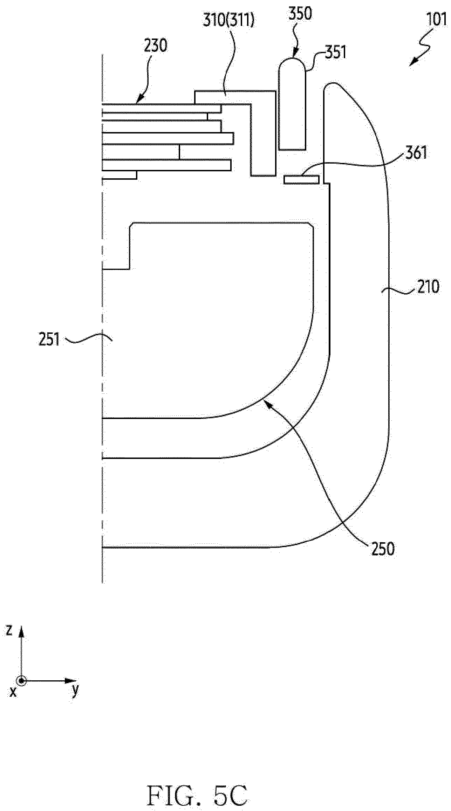

FIG. 5A is a cross-sectional view of an exemplary electronic device cut along A-A' of FIG. 3A. FIG. 5B is a cross-sectional view of an exemplary electronic device cut along B-B' of FIG. 3A. FIG. 5C is a cross-sectional view of an exemplary electronic device cut along C-C' of FIG. 3A.

Referring to FIGS. 5A, 5B, and 5C, a flexible display 230 may be configured with a plurality of layers. For example, the plurality of layers may include a display panel, a window layer, a plurality of sheets, and/or an electromagnetic induction panel, but are not limited thereto. For example, the hinge structure 250 may include a hinge cover 251 located between a first housing 210 and a second housing 220. The hinge cover 251 may include a sweeper 251a filling a space between the first housing 210 and the hinge cover 251 and a space between the second housing 220 and the hinge cover 251. The sweeper 251a may block a foreign substance (e.g., dust) from entering the electronic device 101 through the space between the first housing 210 and the hinge cover 251 and the space between the second housing 220 and the hinge cover 251.

FIG. 5A is a cross-sectional view of the electronic device 101 along the A-A' of FIG. 3A overlapping the folding axis f. Referring to FIG. 5A, a portion of a cap 350 may be in contact with an edge of the cover sheet 310, and a remaining portion of the cap 350 may be located on (e.g., the +z direction) the cover sheet 310. For example, the cap 350 may include a first body 351 in contact with an edge of the cover sheet 310 and a second body 352 bent from the first body 351 and located on the cover sheet 310. For example, the second body 352 may extend along a folding axis (e.g., the folding axis f of FIG. 3A) parallel to the y-axis. The second body 352 may protect and secure the cover sheet 310 on the cover sheet 310 by overlapping the cover sheet 310. The cap 350 may be located on one side (e.g., the +z direction) of the cover sheet 310 overlapping the cap 350, and the support plate 320 may be located on another side (e.g., the -z direction) opposite to the one side. A portion of the cover sheet 310 overlapping the cap 350 may be supported by the cap 350 and the support plate 320.

Referring to FIGS. 5B and 5C, at a position spaced apart from a folding axis (e.g., the folding axis f of FIG. 3A), a cap 350 (e.g., the second body 352 of FIG. 5A) located on the cover sheet 310 may be omitted. Referring to FIG. 5C, a portion of a dust sheet 361 may be located on the hinge cover 251. Since the flexible display 230 and the cover sheet 310 may be deformed according to an operation of the first housing 210, the second housing (e.g., the second housing 220 of FIG. 3A), and/or the hinge structure 250, at a position spaced apart from the folding axis f, the rigid cap 350 may be omitted so as not to interfere with an operation of the first housing 210, the second housing 220, and/or the hinge structure 250. At the position spaced apart from the folding axis f, the cover sheet 310 may be supported by the support plate 320 located below the cover sheet 310. The support plate 320 may be configured to provide rigidity to the cover sheet 310 by supporting entire area of the cover sheet 310 located on the flexible display 230. When the electronic device 101 does not include the support plate 320, only a partial area of the cover sheet 310 may be supported. For example, the cover sheet 310 at a position overlapped with the folding axis f may be supported by the cap 350 (e.g., the second body 352) located on the cover sheet 310, but the cover sheet 310 at a position spaced apart from the folding axis f may not be supported by the cap 350. Since the cover sheet 310 is flexible and not rigid, it may be easily pushed or damaged by an external force. For example, the support plate 320 that supports the entire area of the cover sheet 310 may support areas of the cover sheet 310 that are not supported by the cap 350. Since the cover sheet 310 is supported by the support plate 320, an edge of the deformable third display area 233 may be protected and the inflow of a foreign substance into the electronic device 101 may be blocked.

FIG. 6 illustrates a portion of an exemplary electronic device.

Referring to FIG. 6, a cover sheet 310 may be located on a hinge cover 251. Although omitted in FIG. 6, a third display area (e.g., the third display area 233 in FIG. 3A) may be located on the hinge cover 251. The cover sheet 310 may be configured to block a foreign substance from flowing into an edge of the third display area 233 by being located on the third display area 233.

For example, both ends 310a and 310b of the cover sheet 310 may be connected to a first frame (e.g., the first frame 341 of FIG. 3B) and a second frame (e.g., the second frame 342 of FIG. 3B), respectively. For example, one end 310a of the cover sheet 310 may be hook-coupled to the first frame 341 through a first opening 310c, and another end 310b of the cover sheet 310 may be hook-coupled to the second frame 342 through a second opening 310d. However, it is not limited thereto. When the first frame 341 and the second frame 342 are rotated according to an operation of a first housing (e.g., the first housing 210 of FIG. 3A) and a second housing (e.g., the second housing 220 of FIG. 3A), the cover sheet 310 may be deformed by the rotation. A sweeper 251a may be disposed on the hinge cover 251 to prevent a foreign substance flowing into a space formed as the cover sheet 310 is deformed from entering the electronic device (e.g., the electronic device 101 of FIG. 3A).

For example, the cap 350 may be in contact with the cover sheet 310. For example, the cap 350 may include a first body 351 and a second body 352. The first body 351 may protect an edge 310e of the cover sheet 310 by contacting at least a portion of the edge 310e of the cover sheet 310. For example, the first body 351 may be in contact with at least a portion of the edge 310e of the cover sheet 310 exposed through a gap between the first frame 341 and the second frame 342. The second body 352 may extend from the first body 351 in a direction parallel to the folding axis f and may be located on the cover sheet 310. For example, the second body 352 may extend from the first body 351 in the -y direction along the folding axis f. The second body 352 may fix the cover sheet 310 on the cover sheet 310. The second body 352 may overlap the folding axis f so as not to interfere with a folding operation and an unfolding operation of the electronic device 101. For example, when the electronic device 101 is in a folded state, the second body 352 may be located between a first display area (e.g., the first display area 231 of FIG. 3A) and a second display area (e.g., the second display area 232 of FIG. 3A).

For example, the support plate 320 may be located below (e.g., in the -z direction) the cover sheet 310. For example, the support plate 320 may be located between the hinge cover 251 and the cover sheet 310. The support plate 320 may be configured to support the cover sheet 310 and an edge of the third display area 233 (e.g., the first edge 233a and the second edge 233b of FIG. 3A). For example, in case that an external force is applied to the edges 233a and 233b of the third display area 233, since the support plate 320 under the cover sheet 310 supports the cover sheet 310 and the edges 233a and 233b, the cover sheet 310 may be prevented from being pushed or the edge damaged.

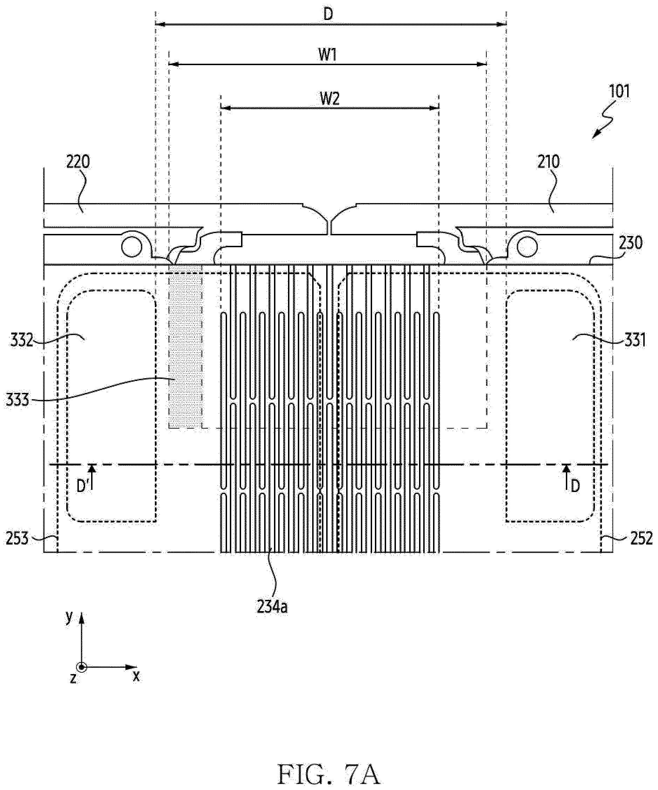

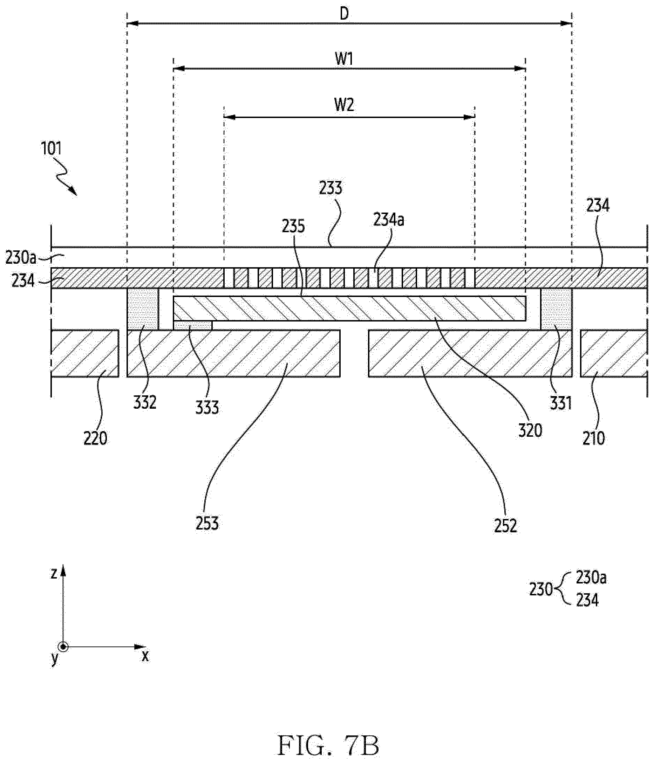

FIG. 7A illustrates a partial area of an exemplary electronic device to which an outer layer of a flexible display (e.g., a window layer or a display panel) is omitted. FIG. 7B is a cross-sectional view of an exemplary electronic device cut along D-D' of FIG. 7A.

Referring to FIGS. 7A and 7B, a flexible display 230 may include a plurality of layers. For example, the flexible display 230 may include a display panel 230a and a conductive plate 234.

For example, the conductive plate 234 may be disposed below (e.g., in the -z direction) a display panel 230a configured to display a visual object. The conductive plate 234 may provide rigidity to the flexible display 230 by supporting the flexible display 230. For example, the conductive plate 234 may include at least one of a metal sheet (e.g., a stainless steel sheet or a copper (Cu) sheet, or carbon fiber reinforced plastics (CFRP), but is not limited thereto. The conductive plate 234 may include a lattice pattern 234a on at least a portion of a position corresponding to the third display area 233. The lattice pattern 234a may include a plurality of openings so that a portion of the conductive plate 234 corresponding to the third display area 233 may be deformed. The plurality of openings may be formed by press processing or laser processing the conductive plate 234.

For example, when the electronic device 101 is in a folded state, a portion of the conductive plate 234 corresponding to the third display area 233 may be bent through the lattice pattern 234a. Although omitted in FIG. 7B, at least one component may be disposed between the conductive plate 234 and the support plate 320. For example, between the conductive plate 234 and the support plate 320, an electromagnetic induction panel configured to receive input from an external electronic device (e.g., a stylus pen), and/or a support member for supporting the first display area 231 and/or the second display area 232 of the flexible display 230, but are not limited thereto.

For example, the third display area 233 may be attached to the hinge structure 250 through attachment members 331 and 332. For example, the third display area 233 may be attached to the first hinge plate 252 through a first attachment member 331 attached to the first hinge plate 252. The third display area 233 may be attached to the second hinge plate 253 through a second attachment member 332 attached to the second hinge plate 253. The attachment members 331 and 332 may be configured to support the third display area 233 from an external force applied to the third display area 233.

For example, the support plate 320 may be attached to either the first hinge plate 252 or the second hinge plate 253 through a third attachment member 333. For example, the support plate 320 may be attached to the second hinge plate 253 through the third attachment member 333 attached to the second hinge plate 253.

For example, the support plate 320 may be disposed below the conductive plate 234. According to a state of the electronic device 101, a shape of a plurality of openings forming the lattice pattern 234a may be deformed. A portion of the conductive plate 234 corresponding to the third display area 233 may be bent in a folded state. In a folded state, a plurality of openings may be deformed. As the plurality of openings are deformed, a portion of the conductive plate 234 corresponding to the third display area 233 may lower a repulsive force due to bending. Since the shape of the plurality of openings forming the lattice pattern 234a may be deformed, the support plate 320 may interfere with the lattice pattern 234a during a folding operation. For example, during the folding operation, the plurality of openings may be opened. When one end 320a of the support plate 320 is attached to the second hinge plate 253 through the third attachment member 333, the support plate 320 may move along the second hinge plate 253 according to the folding operation. Since the one end 320a moves in a state overlapped with the lattice pattern 234a when a width W1 of the support plate 320 is narrower than a width W2 of the lattice pattern 234a, the one end 320a may be sandwiched between the plurality of openings opened while moving according to the folding operation, in the moving process.

For example, a width W1 of the support plate 320 may be wider than a width W2 of the lattice pattern 234a. When the width W1 of the support plate 320 is wider than the width W2 of the lattice pattern 234a, both ends of the support plate 320 may be spaced apart from the lattice pattern 234a in the unfolded state. Since one end of the support plate 320 attached to the second hinge plate 253 moves without overlapping the lattice pattern 234a when both ends of the support plate 320 move in a state spaced apart from the lattice pattern 234a, it may not interfere with the lattice pattern 234a. For example, since the one end of the second hinge plate 253 moves outside the plurality of openings during a folding operation, the one end may not be sandwiched between the plurality of openings. For example, since the width W1 of the support plate 320 is wider than the width W2 of the lattice pattern 234a, interference between the support plate 320 and the lattice pattern 234a may be avoided.

For example, the width W1 of the support plate 320 may be narrower than a distance D between the first attachment member 331 and the second attachment member 332. For example, the support plate 320 may be disposed between the first attachment member 331 attached to the first hinge plate 252 and the second attachment member 332 attached to the second hinge plate 253. When the width W1 of the support plate 320 is greater than the distance D between the first attachment member 331 and the second attachment member 332, an area of the first attachment member 331 and an area of the second attachment member 332 attached to the third display area 233 may be reduced. When the area of the first attachment member 331 and the second attachment member 332 that provide attachment between the third display area 233 and the hinge structure 250 is reduced, an adhesive power between the third display area 233 and the hinge structure 250 may be insufficient. As the width W1 of the support plate 320 is limited to the distance D between the first attachment member 331 and the second attachment member 332, the area of the first attachment member 331 and the area of the second attachment member 332 for providing the adhesive power between the third display area 233 and the hinge structure 250 may be secured.

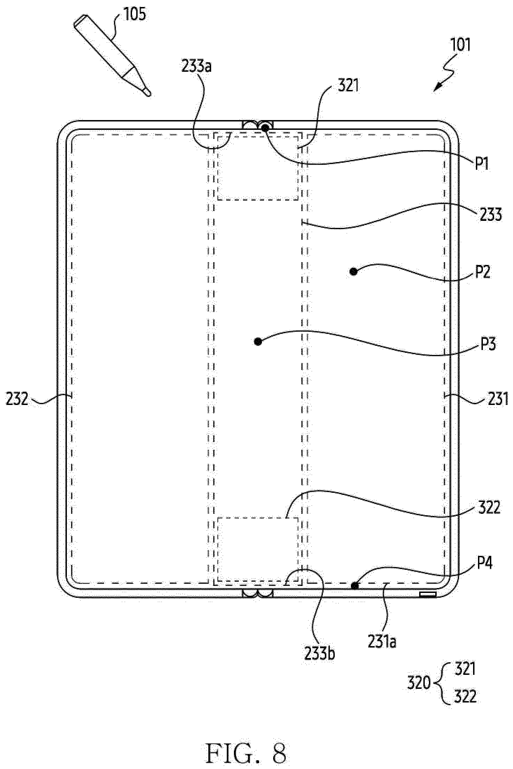

FIG. 8 illustrates a durability test for a flexible display of an exemplary electronic device.

Referring to FIG. 8, a plurality of points P1, P2, P3, and P4 of the flexible display 230 may have different strengths, respectively. For example, durability for each of the plurality of points P1, P2, P3, and P4 of the flexible display 230 may be measured through an experiment in which a load is applied to the plurality of points P1, P2, P3, and P4 of the flexible display 230 using a load measuring instrument 105 having a rounded tip. For example, durability may be measured by measuring a load at a point when breakage occurs when the plurality of points P1, P2, P3, and P4 are pressed by the load measuring instrument 105.

The first point P1 of FIG. 8 may be located in the first edge 233a of the third display area 233. The second point P2 of FIG. 8 may be located inside the first display area 231. The third point P3 of FIG. 8 may be located inside the third display area 233. The fourth point P4 of FIG. 8 may be located within the edge 231a of the first display area 231. [Table 1] below shows results of measuring the durability of the plurality of points P1, P2, P3, and P4 of the flexible display 230, for the electronic device 101 that does not include the support plate 320.

**[Table 1]**

| Position | Durability |
|---|---|
| Point 1 (P1) | 2.5kgf |
| Point 2 (P2) | 6.0kgf |
| Point 3 (P3) | 4.5kgf |
| Point 4 (P4) | 5.0kgf |

Referring to Table 1 above, the durability of the first display area 231 that is always flat regardless of a state of the electronic device 101 may be stronger than the durability of the third display area 233 that may be bent. When the electronic device 101 is in a folded state, since the third display area 233 is a flexible area capable of bending, the third display area 233 may have weaker durability than the first display area 231. The durability of the first edge 233a of the third display area 233 may be weaker than the durability of the inside of the third display area 233 and the edge 231a of the first display area 231. The durability of the first edge 233a and the second edge 233b of the flexible third display area 233 may be the weakest on the flexible display 230. When the electronic device 101 does not include the support plate 320 supporting the first edge 233a and the second edge 233b of the third display area 233, the first edge 233a and the second edge 233b may be easily damaged by an external force. [Table 2] below shows results of measuring the durability of the plurality of points P1, P2, P3, and P4 of the flexible display 230, for the electronic device 101 including the first support plate 321 and the second support plate 322.

**[Table 2]**

| Position | Durability |
|---|---|
| Point 1 (P1) | 3.5kgf |
| Point 2 (P2) | 6.0kgf |
| Point 3 (P3) | 4.5kgf |
| Point 4 (P4) | 5.0kgf |

Referring to Table 2 above, when the electronic device 101 includes the support plate 320, the durability of the first edge 233a of the third display area 233 may be improved. For example, the durability of the first edge 233a may be improved from about 2.5 kgf to about 3.5 kgf. The support plate 320 may be disposed along the first edge 233a and/or the second edge 233b of the third display area 233 and configured to support the first edge 233a and/or the second edge 233b. Since the rigid support plate 320 supports the first edge 233a and/or the second edge 233b, the durability of the first edge 233a and/or the second edge 233b may be improved. Since the first edge 233a and/or the second edge 233b, which are the most vulnerable portion of the flexible display 230, are supported by the support plate 320, the durability of the flexible display 230 may be improved.

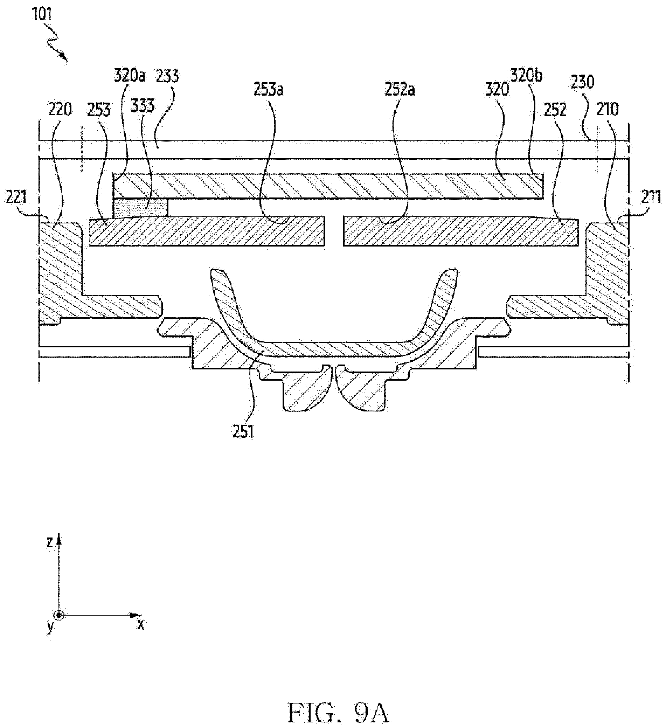

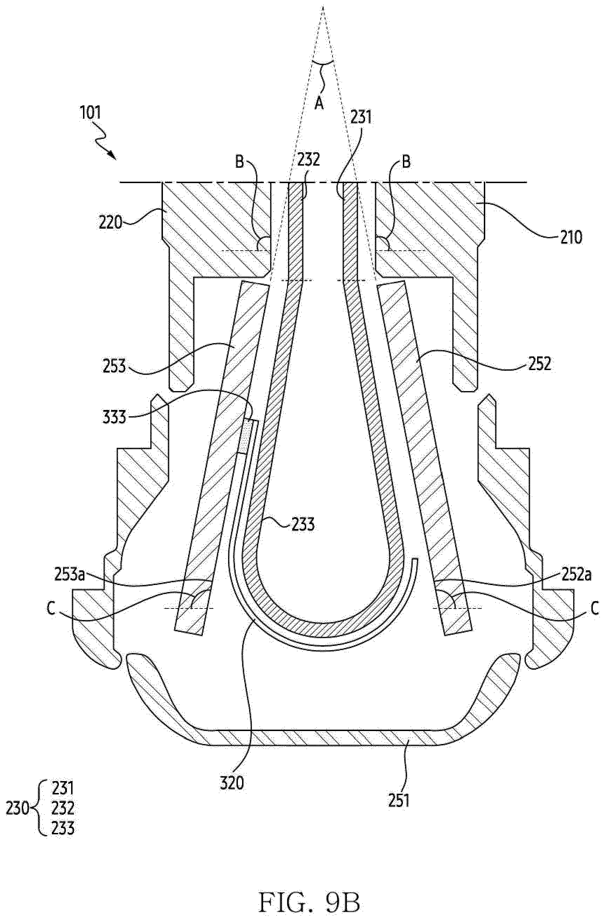

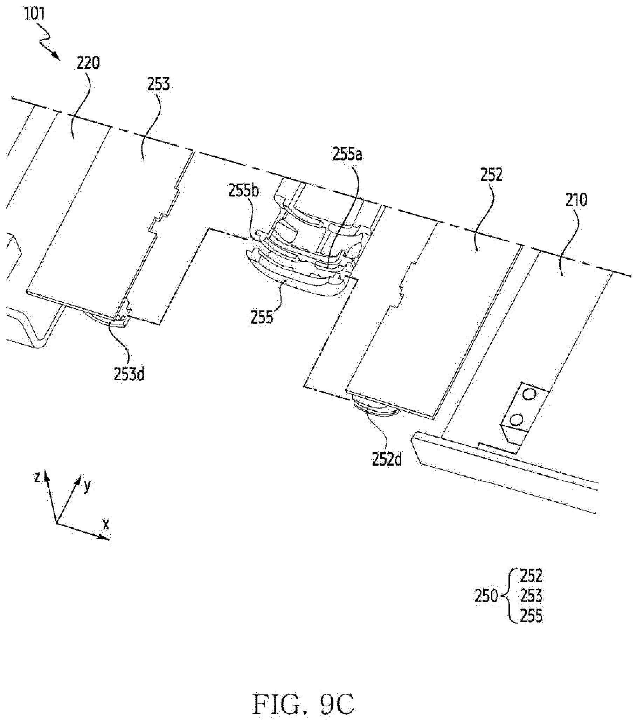

FIG. 9A is a cross-sectional view of an exemplary electronic device in an unfolded state. FIG. 9B is a cross-sectional view of an exemplary electronic device in a folded state. FIG. 9C is an exploded view of a hinge structure of an exemplary electronic device.

Referring to FIGS. 9A and 9B, a support plate 320 may be located on (e.g., in the +z direction) a first hinge plate 252 and a second hinge plate 253. The support plate 320 may be attached to the second hinge plate 253 through an attachment member 333. For example, in an unfolded state, the support plate 320 may be disposed parallel with respect to the first hinge plate 252 and/or the second hinge plate 253. Referring to FIG. 9B, when the electronic device 101 changes from the unfolded state to a folded state, the support plate 320 may be bent while moving along the first hinge plate 252 or the second hinge plate 253. For example, one end 320a of the support plate 320 may be attached to the second hinge plate 253, and another end 320b may move along the one end 320a. When the electronic device 101 changes from the unfolded state to the folded state in a state that the support plate 320 is attached to the second hinge plate 253, a gap between the first hinge plate 252 and the second hinge plate 253 may be opened. The one end 320a of the support plate 320 attached to the second hinge plate 253 may move along the second hinge plate 253, and the other end 320b may move along the one end 320a. Referring to FIG. 9B, in the folded state, a portion of the support plate 320 disposed on the second hinge plate 253 may be flat along the second hinge plate 253, and a remaining portion of the support plate 320 spaced apart from the second hinge plate 253 may be bent along a curved shape of the third display area 233. When the electronic device 101 changes from the folded state to the unfolded state, the support plate 320 may move along the second hinge plate 253 and may be disposed in parallel with the first hinge plate 252 and/or the second hinge plate 253.

For example, the hinge structure 250 may include a hinge cover 251 disposed below (e.g., in the -z direction) the first hinge plate 252 and the second hinge plate 253. The hinge cover 251 may be disposed between the first housing 210 and the second housing 220 for at least partially surrounding the first hinge plate 252 and the second hinge plate 253. For example, at least a portion of the hinge cover 251 may be exposed to the outside through a gap between the first housing 210 and the second housing 220 in the folded state. For example, the hinge cover 251 may be covered by the first housing 210 and the second housing 220 in the unfolded state.

Referring to FIG. 9A, when the electronic device 101 is in the unfolded state, the first hinge plate 252 and the second hinge plate 253 may be disposed on substantially the same plane. When the electronic device 101 is in the unfolded state, the first housing 210 and the second housing 220 may be disposed on substantially the same plane. For example, in the folded state, since one surface 252a of the first hinge plate 252 and one surface 253a of the second hinge plate 253 face substantially the same direction, an angle between the one surface 252a and the one surface 253a may be substantially about 180 degrees. For example, in the unfolded state, the first surface 211 of the first housing 210 and the third surface 221 of the second housing 220 face substantially the same direction, an angle between the first surface 211 and the third surface 221 may be substantially about 180 degrees.

Referring to FIG. 9B, when the electronic device 101 is changed from the unfolded state to the folded state, a rotation angle range of the first housing 210 and/or the second housing 220 and a rotation angle range of the first hinge plate 252 and/or the second hinge plate 253 may be different from each other. According to a difference in the rotation angle range, the third display area 233 of the flexible display 230 may be bent in a water drop shape within the folded state. Within the folded state, the second hinge plate 253 is not parallel to the first hinge plate 252 and may have a slope. For example, within the folded state, a direction in which the one surface 252a of the first hinge plate 252 faces and a direction in which the one surface 253a of the second hinge plate 253 faces may not face opposite directions but may have a slope with respect to each other. For example, an angle (e.g., an angle A of FIG. 9B) between the one surface 252a of the first hinge plate 252 and the one surface 253a of the second hinge plate 253 may be an acute angle smaller than 90 degrees.

For example, when the electronic device 101 changes from the unfolded state to the folded state, a rotation angle range of the first housing 210 and the second housing 220 may be in a first angle range. For example, the first housing 210 and/or the second housing 220 may rotate from the unfolded state where the first housing 210 and the second housing 220 are disposed in parallel on substantially the same plane to the folded state where the first housing 220 and the second housing 220 face each other. Within the unfolded state, an angle between the first surface 211 of the first housing 210 and the third surface 221 of the second housing 220 may be about 180 degrees. Within the folded state, since the first surface 211 of the first housing 210 and the third surface 221 of the second housing 220 are parallel to each other, an angle between the first surface 211 and the third surface 221 may be substantially about 0 degrees.

For example, when the electronic device 101 changes from the unfolded state to the folded state, each of the first housing 210 and the second housing 220 may face each other by rotating about 90 degrees (e.g., an angle B of FIG. 9B) due to an external force (e.g., a force applied by a user). For example, when the electronic device 101 changes from the unfolded state to the folded state, the second housing 220 may face the first housing 210 by rotating about 180 degrees with respect to the first housing 210. For example, when the electronic device 101 changes from the unfolded state to the folded state, the sum of a rotation angle of the first housing 210 and a rotation angle of the second housing 220 may be about 180 degrees. For example, the first angle range may be about 0 degrees to about 180 degrees.

For example, when the electronic device 101 changes from the unfolded state to the folded state, a rotation angle range of the first hinge plate 252 and the second hinge plate 253 may be within a second angle range greater than the first angle range. For example, the first hinge plate 252 and the second hinge plate 253 may rotate from the unfolded state in which the first hinge plate 252 and the second hinge plate 253 are disposed in parallel on substantially the same plane to the folded state in which the first hinge plate 252 and the second hinge plate 253 have a slope with respect to each other. In the unfolded state, an angle between the one surface 252a of the first hinge plate 252 and the one surface 253a of the second hinge plate 253 may be about 180 degrees. In the folded state, the one surface 252a of the first hinge plate 252 and the one surface 253a of the second hinge plate 253 may form an acute angle (e.g., an angle A of FIG. 9B) with respect to each other.

For example, when the electronic device 101 changes from the unfolded state to the folded state, each of the first hinge plate 252 and the second hinge plate 253 may have a slope with respect to each other by rotating by an angle greater than 90 degrees (e.g., an angle C of FIG. 9B). For example, as shown in FIG. 9B, when the electronic device 101 changes from the unfolded state to the folded state, each of the first hinge plate 252 and the second hinge plate 253 may rotate a degree (e.g., 100 degrees) greater than 90 degrees. The angle between one surface 252a of the first hinge plate 252 and one surface 253a of the second hinge plate 253 may be 2a-180 degrees (e.g., 20 degrees). For example, when the electronic device 101 changes from the unfolded state to the folded state, the sum of the rotation angle of the first hinge plate 252 and the rotation angle of the second hinge plate 253 may be greater than 180 degrees. For example, the second angle range may be about 0 degrees to about 200 degrees. However, it is not limited thereto.

The rotation operation of the first hinge plate 252 and the second hinge plate 253 described above may be implemented through the hinge structure 250 illustrated in FIG. 9C. Referring to FIG. 9C, the hinge structure 250 may include a first hinge plate 252, a second hinge plate 253, and a hinge bracket 255. The first hinge plate 252 and the second hinge plate 253 may be coupled to the hinge bracket 255.

For example, the hinge bracket 255 may provide a rotation axis of the first hinge plate 252 and the second hinge plate 253. For example, the hinge bracket 255 may include a first guide groove 255a to which the first hinge plate 252 is slidably connected and a second guide groove 255b to which the second hinge plate 253 is slidably connected. For example, the first hinge plate 252 may include a first coupling portion 252d inserted into the first guide groove 255a and slidable within the first guide groove 255a. For example, the second hinge plate 253 may include a second coupling portion 253d inserted into the second guide groove 255b and slidable within the second guide groove 255b. The first hinge plate 252 may slide along the first guide groove 255a through the first coupling portion 252d, and the second hinge plate 253 may slide along the second guide groove 255b through the second coupling portion 253d. Since the first guide groove 255a and the second guide groove 255b have a curvature, the first coupling portion 252d and the second coupling portion 253d may form a rotation angle while sliding. A general hinge may rotate with respect to a constant rotation axis without changing the rotation axis when rotated. On the other hand, since the first hinge plate 252 and the second hinge plate 253 rotate while sliding along the first guide groove 255a and the second guide groove 255b, the rotation axis may change. For example, as the first hinge plate 252 slides along the first guide groove 255a and the second hinge plate 253 slides along the second guide groove 255b, a gap between the first hinge plate 252 and the second hinge plate 253 may be opened. As the first hinge plate 252 and the second hinge plate 253 are opened, the first hinge plate 252 and the second hinge plate 253 may have a slope with respect to each other, in a state of being completely moved along the first guide groove 255a and the second guide groove 255b.

For example, the electronic device 101 may change from the unfolded state to the folded state by the movement of the first hinge plate 252 and/or the second hinge plate 253. Since the rotation angle range of the first hinge plate 252 and the second hinge plate 253 and the rotation angle range of the first housing 210 and the second housing 220 are different from each other, an exemplary electronic device 101 may provide a structure in which the curvature of the flexible display 230 changes gently, within the folded state. For example, within the folded state, when the first hinge plate 252 and the second hinge plate 253 face each other, the curvature of the flexible display 230 supported by the first hinge plate 252 and the second hinge plate 253 may change rapidly between the first hinge plate 252 and the second hinge plate 253. For example, within the folded state, the first hinge plate 252 and the second hinge plate 253 are inclined with respect to each other, so that the curvature change of the flexible display 230 may be gentle. Since the curvature of the flexible display 230 is gently changed, damage to the flexible display 230 may be reduced. For example, within the folded state, the formation of wrinkles in an area where the flexible display 230 is folded (e.g., the third display area 233) may be reduced.

An electronic device (e.g., the electronic device 101 of FIG. 3A) is provided. The electronic device may include a first housing (e.g., the first housing 210 of FIG. 3A), a second housing (e.g., the second housing 220 of FIG. 3A), a flexible display (e.g., the flexible display 230 of FIG. 3A), a cover sheet (e.g., the cover sheet 310 of FIG. 3B), and a support plate (e.g., the support plate 320 of FIG. 3B). The second housing may be rotatable to the first housing with respect to a folding axis (e.g., the folding axis f of FIG. 3A). The flexible display may include a first display area (e.g., the first display area 231 of FIG. 3A), a second display area (e.g., the second display area 232 of FIG. 3A), and a third display area (e.g., the third display area 233 of FIG. 3A). The first display area may be disposed on the first housing. The second display area may be disposed on the second housing. The third display area may be disposed along the folding axis between the first display area and the second display area. The third display area may be deformed based on the second housing being rotated with respect to the first housing. The cover sheet may be disposed along at least a portion of an edge (e.g., the first edge 233a and the second edge 233b of FIG. 3A) of the third display area intersecting the folding axis. The support plate may be located below the cover sheet to support the cover sheet. The support plate may extend along the folding axis from at least a portion of the edge. According to an embodiment, the edge of the third display area and the cover sheet may be supported by the support plate. The support plate may provide rigidity to the edge of the third display area by supporting the cover sheet under the cover sheet.. Since the cover sheet is flexible and not rigid, it may be easily pushed or damaged by an external force. By supporting the cover sheet by the support plate, the edge of the deformable third display area may be protected and the inflow of a foreign substance into the electronic device may be blocked.

For example, the third display area may include a first edge (e.g., the first edge 233a of FIG. 3A) and a second edge (e.g., the second edge 233b of FIG. 3A). The first edge may intersect the folding axis. The second edge may be opposite to the first edge. The cover sheet may include a first cover sheet (e.g., the first cover sheet 311 of FIG. 3B) and a second cover sheet (e.g., the second cover sheet 312 of FIG. 3B). The first cover sheet may be disposed along at least a portion of the first edge. The second cover sheet may be spaced apart from the first cover sheet in a direction parallel to the folding axis. The second cover sheet may be disposed along at least a portion of the second edge.

For example, the support plate may include a first support plate (e.g., the first support plate 321 of FIG. 3B) and a second support plate (e.g., the second support plate 322 of FIG. 3B). The first support plate may be located below the first cover sheet to support the first cover sheet. The second support plate may be located below the second cover sheet to support the second cover sheet.

For example, the second support plate may be spaced apart from the first support plate in a direction parallel to the folding axis.

For example, a length of the support plate extending along the folding axis may be shorter than a length of the third display area extending along the folding axis. According to an embodiment, the first support plate and the second support plate may be spaced apart from each other along the folding axis. The first support plate and the second support plate spaced apart from each other respectively support the first cover sheet and the second cursor sheet, and may not interfere with a rotation operation of the hinge structure. The first support plate and the second support plate are disposed only in an area for supporting the cover sheet, so that unnecessary a subsidiary material is not required, it does not interfere with the repeatedly rotating hinge structure 250, and the manufacturing cost may be lowered.

For example, the support plate may overlap the cover sheet. According to an embodiment, the support plate may be configured to support an edge of the third display area by overlapping the cover sheet. For example, when the electronic device is viewed from above, at least a portion of the support plate may be configured to support the cover sheet by overlapping the cover sheet. For example, when an external force is applied to the edge of the third display area, since the support plate below the cover sheet supports the cover sheet and the edge, the cover sheet may be prevented from being pushed or the edge damaged.

An exemplary electronic device may further include a hinge structure (e.g., the hinge structure 250 of FIG. 3A). The hinge structure may include a first hinge plate (e.g., the first hinge plate 252 of FIG. 3A) and a second hinge plate (e.g., the second hinge plate 253 of FIG. 3A). The first hinge plate may be connected to the first housing. The second hinge plate may be connected to the second housing. The second hinge plate may be rotatable to the first hinge plate with respect to the folding axis. The support plate may be located between the hinge structure and the flexible display. According to an embodiment, the support plate may be disposed on a hinge structure to support the cover sheet.

For example, the support plate may be attached to either the first hinge plate or the second hinge plate. According to an embodiment, the support plate may be attached to either the first hinge plate or the second hinge plate so as not to interfere with a rotation operation of the hinge structure. For example, in a state that a portion of the support plate is attached to the second hinge plate, when the electronic device changes from the unfolded state to the folded state, a gap between the first hinge plate and the second hinge plate may be opened. One end of the support plate attached to the second hinge plate may move along the second hinge plate, and another end may move along the one end. Within the unfolded state, a portion of the support plate disposed on the second hinge plate may be flat along the second hinge plate, and a remaining portion of the support plate spaced apart from the second hinge plate may be bent along a curved shape of the third display area.

For example, the flexible display may include a lattice pattern (e.g., the lattice pattern 234a of FIG. 7A). The lattice pattern may include a plurality of recesses for deformation of the third display area. A width (e.g., the width W1 of FIG. 7A) of the support plate may be wider than a width (e.g., the width W2 of FIG. 7A) of the lattice pattern. According to an embodiment, the width of the support plate may be wider than the width of the lattice pattern. When the width of the support plate is wider than the width of the lattice pattern, within the unfolded state, both ends of the support plate may be spaced apart from the lattice pattern. When both ends of the support plate move while spaced apart from the lattice pattern, one end of the support plate attached to the second hinge plate moves without overlapping the lattice pattern, so it may not interfere with the lattice pattern. For example, since one end of the second hinge plate moves outside of a plurality of openings during a folding operation, the one end may not be sandwiched between a plurality of openings. For example, since the width of the support plate is wider than the width of the lattice pattern, interference between the support plate and the lattice pattern may be avoided.

An exemplary electronic device may further include a hinge structure. The hinge structure may include a first hinge plate and a second hinge plate. The first hinge plate may be connected to the first housing. The second hinge plate may be connected to the second housing. The second hinge plate may be rotatable to the first hinge plate with respect to the folding axis. The hinge structure may include a first attachment member and a second attachment member. The first attachment member may be disposed on the first hinge plate. The first attachment member may be attached to the flexible display. The second attachment member may be disposed on the second hinge plate. The second attachment member may be attached to the flexible display. The support plate may be disposed between the first attachment member and the second attachment member.

An exemplary electronic device may further include a first frame (e.g., the first frame 341 of FIG. 3B) and a second frame (e.g., the second frame 342 of FIG. 3B). The first frame may at least partially surround edges of the first display area. The second frame may be spaced apart from the first frame. The second frame may at least partially surround edges of the second display area. The cover sheet may cover a gap between the first frame and the second frame. According to an embodiment, the cover sheet may cover a gap between the first frame and the second frame. For example, the cover sheet may block a foreign substance (e.g., dust) from entering the electronic device, by covering the edge of the third display area exposed through the gap between the first frame and the second frame. For example, the cover sheet may block a foreign substance flowing through a space between the third display area and the first housing and a space between the third display area and the second housing.

For example, a width of the support plate may be wider than a gap between the first frame and the second frame. According to an embodiment, the support plate may be wider than the gap so as to support the cover sheet exposed through the gap between the first frame and the second frame.

For example, the cover sheet may include one end (e.g., the one end portion 310a of FIG. 6) and another end (e.g., the other end 310b of FIG. 6). The one end may be connected to a surface of the first frame facing the first display area. The other end portion may be connected to a surface of the second frame facing the second display area. According to an embodiment, both ends of the cover sheet may be connected to the first frame and the second frame, respectively. For example, the one end of the cover sheet may be hook-coupled to the first frame through the first opening, and the other end of the cover sheet may be hook-coupled to the second frame through the second opening. When the first frame and the second frame are rotated according to an operation of the first housing and the second housing, the cover sheet may be deformed by the rotation.

An exemplary electronic device may further include a cap (e.g., the cap 350 of FIG. 6). The cap may be disposed in the gap between the first frame and the second frame. The cap may be in contact with the cover sheet. The cap may include a first body (e.g., the first body 351 of FIG. 6) and a second body (e.g., the second body 352 of FIG. 6). The first body may be in contact with the edge of the cover sheet. The second body may extend from the first body in a direction parallel to the folding axis. The second body may be located on the cover sheet to fix the cover sheet.

For example, in a folded state where a direction toward which the first display area faces is opposite to a direction toward which the second display area faces, the second body may be located between the first display area and the second display area. According to an embodiment, the first body may protect the edge of the cover sheet by contacting at least a portion of the edge of the cover sheet. For example, the first body may be in contact with the edge of the cover sheet exposed through a gap between the first frame and the second frame. The second body may extend from the first body in a direction parallel to the folding axis and may be located on the cover sheet. The second body may fix the cover sheet on the cover sheet. The second body may overlap the folding axis so as not to interfere with a folding operation and an unfolding operation of the electronic device. For example, when the electronic device is in a folded state, the second body may be located between the first display area and the second display area.

An electronic device (e.g., the electronic device 101 of FIG. 3A) is provided. The electronic device may include a first housing (e.g., the first housing 210 of FIG. 3A), a second housing (e.g., the second housing 220 of FIG. 3A), a flexible display (e.g., the flexible display 230 of FIG. 3A), a cover sheet (e.g., the cover sheet 310 of FIG. 3B), a support plate (e.g., the support plate 320 of FIG. 3B), and a hinge structure (e.g., the hinge structure 250 of FIG. 3A). The second housing may be rotatable to the first housing with respect to a folding axis (e.g., the folding axis f of FIG. 3A). The flexible display may include a first display area (e.g., the first display area 231 of FIG. 3A), a second display area (e.g., the second display area 232 of FIG. 3A), and a third display area (e.g., the third display area 233 of FIG. 3A). The first display area may be disposed on the first housing. The second display area may be disposed on the second housing. The third display area may be disposed along the folding axis between the first display area and the second display area. The third display area may be deformed based on the second housing being rotated with respect to the first housing. The cover sheet may be disposed along at least a portion of an edge (e.g., the first edge 233a and the second edge 233b of FIG. 3A) of the third display area intersecting the folding axis. The support plate may be located below the cover sheet to support the cover sheet. The support plate may extend along the folding axis from at least a portion of the edge. The hinge structure may include a first hinge plate and a second hinge plate. The first hinge plate may be connected to the first housing. The second hinge plate may be connected to the second housing. The second hinge plate may be rotatable to the first hinge plate with respect to the folding axis. The support plate may be located between the hinge structure and the flexible display. A rotation angle range of the first hinge plate and the second hinge plate may be greater than a rotation angle range of the first housing and the second housing. According to an embodiment, the hinge structure may rotate the third display area of the flexible display to bend into a water drop shape within the folded state. For example, while a state of the electronic device changes from the unfold state to the folded state, each of the first housing and the second housing may rotate by about 90 degrees, and each of the first hinge plate and the second hinge plate may rotate by about 100 degrees. For example, within the folded state, since the first hinge plate and the second hinge plate are inclined with respect to each other, a change in curvature of the flexible display may be gentle. Since the curvature of the flexible display is gradually changed, damage to the flexible display may be reduced. For example, within the folded state, the formation of wrinkles in an area where the flexible display is folded (e.g., the third display area).

For example, the support plate may be located between the hinge structure and the flexible display.

For example, the support plate may be attached to either the first hinge plate or the second hinge plate.

For example, the third display area may include a first edge (e.g., the first edge 233a of FIG. 3A) and a second edge (e.g., the second edge 233b of FIG. 3A). The first edge may intersect the folding axis. The second edge may be opposite to the first edge. The cover sheet may include a first cover sheet (e.g., the first cover sheet 311 of FIG. 3B) and a second cover sheet (e.g., the second cover sheet 312 of FIG. 3B). The first cover sheet may be disposed along at least a portion of the first edge. The second cover sheet may be spaced apart from the first cover sheet in a direction parallel to the folding axis. The second cover sheet may be disposed along at least a portion of the second edge.

For example, the support plate may include a first support plate (e.g., the first support plate 321 of FIG. 3B) and a second support plate (e.g., the second support plate 322 of FIG. 3B). The first support plate may be located below the first cover sheet to support the first cover sheet. The second support plate may be located below the second cover sheet to support the second cover sheet.

For example, the second support plate may be spaced apart from the first support plate in a direction parallel to the folding axis.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a first housing (210);
a second housing (220) rotatable with respect to the first housing (210) with respect to a folding axis (f);
a flexible display (230) including a first display area (231) disposed on the first housing (210), a second display area (232) disposed on the second housing (220), and a third display area (233) disposed along the folding axis (f) between the first display area (231) and the second display area (232) and deformed based on the second housing (220) being rotated with respect to the first housing (210); and
a cover sheet (310) disposed along at least a portion of edge (233a, 233b) of the third display area (233) intersecting the folding axis (f);
**characterised in that**
the electronic device further comprises a support plate (320) located below the cover sheet (310) to support the cover sheet (310), and extending from at least a portion of the edge (233a, 233b) along the folding axis (f).

2. The electronic device (101) of claim 1,
wherein the third display area (233) includes a first edge (233a) intersecting the folding axis (f), and a second edge (233b) opposite to the first edge (233a), and
wherein the cover sheet (310) includes a first cover sheet (311) disposed along at least portion of the first edge (233a), and a second cover sheet (312) spaced apart from the first cover sheet (311) in a direction parallel to the folding axis (f) and disposed along at least portion of the second edge (233b).

3. The electronic device (101) of claim 2,
wherein the support plate (320) includes a first support plate (321) located below the first cover sheet (311) to support the first cover sheet (311), and a second support plate (322) located below the second cover sheet (312) to support the second cover sheet (312).

4. The electronic device (101) of claim 3,
wherein the second support plate (322) is spaced apart from the first support plate (321) in the direction parallel to the folding axis (f).

5. The electronic device (101) of any one of claims 1 to 4,
wherein a length of the support plate (320) extending along the folding axis (f) is shorter than a length of the third display area (233) extending along the folding axis (f).

6. The electronic device (101) of any one of claims 1 to 5,
wherein the support plate (320) overlaps the cover sheet (310).

7. The electronic device (101) of any one of claims 1 to 6, further comprising a hinge structure (250) including a first hinge plate (252) connected to the first housing (210), and a second hinge plate (253) connected to the second housing (220) and rotatable to the first hinge plate (252) with respect to the folding axis (f), and
wherein the support plate (320) is located between the hinge structure (250) and the flexible display (230).

8. The electronic device (101) of claim 7,
wherein the support plate (320) is attached to either the first hinge plate (252) or the second hinge plate (253).

9. The electronic device (101) of any one of claims 1 to 8,
wherein the flexible display comprises lattice pattern (234a) comprising a plurality of recesses for deformation of the third display area (233), and
wherein a width (W1) of the support plate (320) is wider than a width (W2) of the lattice pattern (234a).

10. The electronic device (101) of any one of claims 1 to 9, further comprising the hinge structure (250) including the first hinge plate (252) connected to the first housing (210), and the second hinge plate (253) connected to the second housing (220) and rotatable to the first hinge plate (252) with respect to the folding axis (f),
wherein the hinge structure (250) includes a first attachment member (331) disposed on the first hinge plate (252) and attached to the flexible display (230), and a second attachment member (332) disposed on the second hinge plate (253) and attached to the flexible display (230), and
wherein the support plate (320) is disposed between the first attachment member (331) and the second attachment member (332).

11. The electronic device (101) of any one of claims 1 to 10, further comprising:
a first frame (341) at least partially surrounding edges of the first display area (231); and
a second frame (342) spaced apart from the first frame (341) and at least partially surrounding edges of the second display area (232), and
wherein the cover sheet (310) covers a gap between the first frame (341) and the second frame (342).

12. The electronic device (101) of claim 11,
wherein a width (W1) of the support plate (320) is wider than the gap between the first frame (341) and the second frame (342).

13. The electronic device (101) of any one of claims 11 or 12,
wherein the cover sheet (310) includes one end (310a) connected to a surface of the first frame (341) facing the first display area (231), and another end (310b) connected to a surface of the second frame (342) facing the second display area (232).

14. The electronic device (101) of any one of claims 11 to 13, further comprising a cap (350) disposed on the gap between the first frame (341) and the second frame (342), and in contact with the cover sheet (310),
wherein the cap includes a first body (351) in contact with an edge of the cover sheet (310), and a second body (352) extending from the first body (351) in a direction parallel to the folding axis (f) and fixing the cover sheet (310) by being located on the cover sheet (310).

15. The electronic device (101) of claim 14,
wherein the second body (352) is located between the first display area (231) and the second display area (232), in a folded state in which a direction in which the first display area (231) faces is opposite to a direction in which the second display area (232) faces.

## Patentansprüche

1. Elektronische Vorrichtung (101), umfassend:
ein erstes Gehäuse (210);
ein zweites Gehäuse (220), das in Bezug auf das erste Gehäuse (210) in Bezug auf eine Klappachse (f) drehbar ist;
eine flexible Anzeige (230), die einen ersten Anzeigebereich (231), der an dem ersten Gehäuse (210) angeordnet ist, einen zweiten Anzeigebereich (232), der an dem zweiten Gehäuse (220) angeordnet ist, und einen dritten Anzeigebereich (233), der entlang der Klappachse (f) zwischen dem ersten Anzeigebereich (231) und dem zweiten Anzeigebereich (232) angeordnet und basierend darauf verformt ist, dass das zweite Gehäuse (220) in Bezug auf das erste Gehäuse (210) gedreht wird, beinhaltet; und
eine Decklage (310), die entlang zumindest eines Abschnittes der Kante (233a, 233b) des dritten Anzeigebereichs (233) angeordnet ist, der die Klappachse (f) schneidet;
**dadurch gekennzeichnet, dass**
die elektronische Vorrichtung ferner eine Stützplatte (320) umfasst, die sich unter der Decklage (310) befindet, um die Decklage (310) zu stützen, und sich von zumindest einem Abschnitt der Kante (233a, 233b) entlang der Klappachse (f) erstreckt.

2. Elektronische Vorrichtung (101) nach Anspruch 1,
wobei der dritte Anzeigebereich (233) eine erste Kante (233a), welche die Klappachse (f) schneidet, und eine zweite Kante (233b) gegenüber der ersten Kante (233a) beinhaltet, und
wobei die Decklage (310) eine erste Decklage (311), die entlang zumindest eines Abschnittes der ersten Kante (233a) angeordnet ist, und eine zweite Decklage (312), die von der ersten Decklage (311) in einer Richtung parallel zu der Klappachse (f) beabstandet und entlang zumindest eines Abschnittes der zweiten Kante (233b) angeordnet ist, beinhaltet.

3. Elektronische Vorrichtung (101) nach Anspruch 2, wobei die Stützplatte (320) eine erste Stützplatte (321), die sich unter der ersten Decklage (311) befindet, um die erste Decklage (311) zu stützen, und eine zweite Stützplatte (322), die sich unter der zweiten Decklage (312) befindet, um die zweite Decklage (312) zu stützen, beinhaltet.

4. Elektronische Vorrichtung (101) nach Anspruch 3, wobei die zweite Stützplatte (322) von der ersten Stützplatte (321) in der Richtung parallel zu der Klappachse (f) beabstandet ist.

5. Elektronische Vorrichtung (101) nach einem der Ansprüche 1 bis 4,
wobei eine Länge der Stützplatte (320), die sich entlang der Klappachse (f) erstreckt, kürzer als eine Länge des dritten Anzeigebereichs (233) ist, der sich entlang der Klappachse (f) erstreckt.

6. Elektronische Vorrichtung (101) nach einem der Ansprüche 1 bis 5,
wobei die Stützplatte (320) die Decklage (310) überlappt.

7. Elektronische Vorrichtung (101) nach einem der Ansprüche 1 bis 6, ferner umfassend eine Scharnierstruktur (250), die eine erste Scharnierplatte (252), die mit dem ersten Gehäuse (210) verbunden ist, und eine zweite Scharnierplatte (253), die mit dem zweiten Gehäuse (220) verbunden und zu der ersten Scharnierplatte (252) in Bezug auf die Klappachse (f) drehbar ist, beinhaltet, und
wobei sich die Stützplatte (320) zwischen der Scharnierstruktur (250) und der flexiblen Anzeige (230) befindet.

8. Elektronische Vorrichtung (101) nach Anspruch 7, wobei die Stützplatte (320) entweder an der ersten Scharnierplatte (252) oder der zweiten Scharnierplatte (253) angebracht ist.

9. Elektronische Vorrichtung (101) nach einem der Ansprüche 1 bis 8,
wobei die flexible Anzeige Gittermuster (234a) umfasst, das eine Vielzahl von Aussparungen zur Verformung des dritten Anzeigebereichs (233) umfasst, und
wobei eine Breite (W1) der Stützplatte (320) breiter als eine Breite (W2) des Gittermusters (234a) ist.

10. Elektronische Vorrichtung (101) nach einem der Ansprüche 1 bis 9, ferner umfassend die Scharnierstruktur (250), welche die erste Scharnierplatte (252), die mit dem ersten Gehäuse (210) verbunden ist, und die zweite Scharnierplatte (253), die mit dem zweiten Gehäuse (220) verbunden und zu der ersten Scharnierplatte (252) in Bezug auf die Klappachse (f) drehbar ist, beinhaltet,
wobei die Scharnierstruktur (250) ein erstes Anbringungselement (331), das an der ersten Scharnierplatte (252) angeordnet und an der flexiblen Anzeige (230) angebracht ist, und ein zweites Anbringungselement (332), das an der zweiten Scharnierplatte (253) angeordnet und an der flexiblen Anzeige (230) angebracht ist, beinhaltet, und
wobei die Stützplatte (320) zwischen dem ersten Anbringungselement (331) und dem zweiten Anbringungselement (332) angeordnet ist.

11. Elektronische Vorrichtung (101) nach einem der Ansprüche 1 bis 10, ferner umfassend:
einen ersten Rahmen (341), der Kanten des ersten Anzeigebereichs (231) zumindest teilweise umgibt; und
einen zweiten Rahmen (342), der von dem ersten Rahmen (341) beabstandet ist und Kanten des zweiten Anzeigebereichs (232) zumindest teilweise umgibt, und wobei die Decklage (310) einen Spalt zwischen dem ersten Rahmen (341) und dem zweiten Rahmen (342) abdeckt.

12. Elektronische Vorrichtung (101) nach Anspruch 11, wobei eine Breite (W1) der Stützplatte (320) breiter als der Spalt zwischen dem ersten Rahmen (341) und dem zweiten Rahmen (342) ist.

13. Elektronische Vorrichtung (101) nach einem der Ansprüche 11 oder 12,
wobei die Decklage (310) ein Ende (310a), das mit einer Fläche des ersten Rahmens (341) verbunden ist, die dem ersten Anzeigebereich (231) zugewandt ist, und ein anderes Ende (310b), das mit einer Fläche des zweiten Rahmens (342) verbunden ist, die dem zweiten Anzeigebereich (232) zugewandt ist, beinhaltet.

14. Elektronische Vorrichtung (101) nach einem der Ansprüche 11 bis 13, ferner umfassend eine Kappe (350), die an dem Spalt zwischen dem ersten Rahmen (341) und dem zweiten Rahmen (342) angeordnet und in Kontakt mit der Decklage (310) ist,
wobei die Kappe einen ersten Körper (351) in Kontakt mit einer Kante der Decklage (310) und einen zweiten Körper (352), der sich von dem ersten Körper (351) in einer Richtung parallel zu der Klappachse (f) erstreckt und die Decklage (310) fixiert, indem er sich an der Decklage (310) befindet, beinhaltet.

15. Elektronische Vorrichtung (101) nach Anspruch 14, wobei sich der zweite Körper (352) zwischen dem ersten Anzeigebereich (231) und dem zweiten Anzeigebereich (232) in einem gefalteten Zustand befindet, in dem eine Richtung, in die der erste Anzeigebereich (231) weist, entgegengesetzt zu einer Richtung ist, in die der zweite Anzeigebereich (232) weist.

## Revendications

1. Dispositif électronique (101) comprenant :
un premier boîtier (210) ;
un second boîtier (220) pouvant tourner par rapport au premier boîtier (210) par rapport à un axe de pliage (f) ;
un écran souple (230) comprenant une première zone d'écran (231) disposée sur le premier boîtier (210), une deuxième zone d'écran (232) disposée sur le second boîtier (220), et une troisième zone d'écran (233) disposée le long de l'axe de pliage (f) entre la première zone d'écran (231) et la deuxième zone d'écran (232) et déformée sur la base de la rotation du second boîtier (220) par rapport au premier boîtier (210) ; et
une feuille de couverture (310) disposée le long d'au moins une partie du bord (233a, 233b) de la troisième zone d'écran (233) coupant l'axe de pliage (f) ;
**caractérisé en ce que**
le dispositif électronique comprend en outre une plaque de support (320) située sous la feuille de couverture (310) pour supporter la feuille de couverture (310), et s'étendant à partir d'au moins une partie du bord (233a, 233b) le long de l'axe de pliage (f).

2. Dispositif électronique (101) de la revendication 1,
ladite troisième zone d'écran (233) comprenant un premier bord (233a) coupant l'axe de pliage (f), et un second bord (233b) à l'opposé du premier bord (233a), et
ladite feuille de couverture (310) comprenant une première feuille de couverture (311) disposée le long d'au moins une partie du premier bord (233a), et une seconde feuille de couverture (312) espacée de la première feuille de couverture (311) dans une direction parallèle à l'axe de pliage (f) et disposée le long d'au moins une partie du second bord (233b).

3. Dispositif électronique (101) de la revendication 2,
ladite plaque de support (320) comprenant une première plaque de support (321) située sous la première feuille de couverture (311) pour supporter la première feuille de couverture (311), et une seconde plaque de support (322) située sous la seconde feuille de couverture (312) pour supporter la seconde feuille de couverture (312).

4. Dispositif électronique (101) de la revendication 3,
ladite seconde plaque de support (322) étant espacée de la première plaque de support (321) dans la direction parallèle à l'axe de pliage (f).

5. Dispositif électronique (101) de l'une quelconque des revendications 1 à 4,
une longueur de la plaque de support (320) s'étendant le long de l'axe de pliage (f) étant plus courte qu'une longueur de la troisième zone d'écran (233) s'étendant le long de l'axe de pliage (f).

6. Dispositif électronique (101) de l'une quelconque des revendications 1 à 5,
ladite plaque de support (320) chevauchant la feuille de couverture (310).

7. Dispositif électronique (101) de l'une quelconque des revendications 1 à 6, comprenant en outre une structure de charnière (250) comprenant une première plaque de charnière (252) raccordée au premier boîtier (210), et une seconde plaque de charnière (253) raccordée au second boîtier (220) et pouvant tourner sur la première plaque de charnière (252) par rapport à l'axe de pliage (f), et
ladite plaque de support (320) étant située entre la structure de charnière (250) et l'écran souple (230).

8. Dispositif électronique (101) de la revendication 7,
ladite plaque de support (320) étant fixée soit à la première plaque de charnière (252) soit à la seconde plaque de charnière (253).

9. Dispositif électronique (101) de l'une quelconque des revendications 1 à 8,
ledit écran souple comprenant un motif en treillis (234a) comprenant une pluralité d'évidements pour la déformation de la troisième zone d'écran (233), et
une largeur (W1) de la plaque de support (320) étant plus large qu'une largeur (W2) du motif en treillis (234a).

10. Dispositif électronique (101) de l'une quelconque des revendications 1 à 9, comprenant en outre une structure de charnière (250) comprenant la première plaque de charnière (252) raccordée au premier boîtier (210), et la seconde plaque de charnière (253) raccordée au second boîtier (220) et pouvant tourner sur la première plaque de charnière (252) par rapport à l'axe de pliage (f),
ladite structure de charnière (250) comprenant un premier élément de fixation (331) disposé sur la première plaque de charnière (252) et fixé à l'écran souple (230), et un second élément de fixation (332) disposé sur la seconde plaque de charnière (253) et fixé à l'écran souple (230), et
ladite plaque de support (320) étant disposée entre le premier élément de fixation (331) et le second élément de fixation (332).

11. Dispositif électronique (101) de l'une quelconque des revendications 1 à 10, comprenant en outre :
un premier cadre (341) entourant au moins partiellement les bords de la première zone d'écran (231) ; et
un second cadre (342) espacé du premier cadre (341) et entourant au moins partiellement les bords de la deuxième zone d'écran (232), et
ladite feuille de couverture (310) couvrant un espace entre le premier cadre (341) et le second cadre (342).

12. Dispositif électronique (101) de la revendication 11,
une largeur (W1) de la plaque de support (320) étant plus large que l'espace entre le premier cadre (341) et le second cadre (342).

13. Dispositif électronique (101) de l'une quelconque des revendications 11 ou 12,
ladite feuille de couverture (310) comprenant une extrémité (310a) raccordée à une surface du premier cadre (341) faisant face à la première zone d'écran (231), et une autre extrémité (310b) raccordée à une surface du second cadre (342) faisant face à la deuxième zone d'écran (232).

14. Dispositif électronique (101) de l'une quelconque des revendications 11 à 13, comprenant en outre un capuchon (350) disposé sur l'espace entre le premier cadre (341) et le second cadre (342), et en contact avec la feuille de couverture (310),
ledit capuchon comprenant un premier corps (351) en contact avec un bord de la feuille de couverture (310), et un second corps (352) s'étendant à partir du premier corps (351) dans une direction parallèle à l'axe de pliage (f) et fixant la feuille de couverture (310) en étant situé sur la feuille de couverture (310).

15. Dispositif électronique (101) de la revendication 14,
ledit second corps (352) étant situé entre la première zone d'écran (231) et la deuxième zone d'écran (232), dans un état plié dans lequel une direction dans laquelle la première zone d'écran (231) est orientée est opposée à une direction dans laquelle la deuxième zone d'écran (232) est orientée.
